# FASCICULE DE BREVET EUROPEEN

(11) **EP 4 006 998 B1**
(45) Date de publication et mention de la délivrance du brevet: **03.01.2024**
(21) Numéro de dépôt: 21209036.9
(22) Date de dépôt: 18.11.2021
(51) Int. Cl.: H10N 30/072, H01L 21/77, H01L 21/78, H01L 21/786, H01L 21/18

(54) **PROCEDE DE FABRICATION D'UN COMPOSANT COMPRENANT UNE COUCHE EN MATERIAU MONOCRISTALLIN COMPATIBLE AVEC DES BUDGETS THERMIQUES ELEVES**
VERFAHREN ZUR HERSTELLUNG EINES BAUTEILS MIT EINER SCHICHT AUS MONOKRISTALLINEM MATERIAL, DAS MIT HOHEN WÄRMEHAUSHALTEN KOMPATIBEL IST
METHOD FOR MANUFACTURING A COMPONENT COMPRISING A LAYER OF MONOCRYSTALLINE MATERIAL COMPATIBLE WITH HIGH THERMAL BUDGETS

(30) Priorité: 26.11.2020 FR 2012176
(43) Date de publication de la demande: 01.06.2022
(73) Titulaire: Commissariat à l'Energie Atomique et aux Energies Alternatives, 75015 Paris (FR)
(72) Inventeur: BOUSQUET, Marie, 38054 Grenoble Cedex 09 (FR); PERREAU, Pierre, 38054 Grenoble Cedex 09 (FR); REINHARDT, Alexandre, 38054 Grenoble Cedex 09 (FR)
(74) Mandataire: Atout PI Laplace

(56) Documents cités:
- EP-A2- 2 388 840
- CN-A- 107 800 396
- FR-A1- 2 857 983
- FR-A1- 3 082 997

## Description

Le domaine de l'invention est celui des composants comprenant au moins une couche de matériau piézoélectrique ou pyroélectrique ou ferroélectrique, reportée sur un substrat final.

Dans le domaine des composants acoustiques radiofréquences pouvant comprendre une couche piézoélectrique, on peut citer les composants permettant la réalisation de résonateurs ou de filtres passifs, compacts, et présentant de forts coefficients de qualité ou de fortes réjections, en substituant à la propagation d'ondes électriques la propagation d'ondes élastiques dans des milieux solides. Ces filtres sont tout particulièrement employés dans les systèmes de communication sans fil, où ils permettent une ségrégation des nombreux signaux captés par les antennes d'un terminal de communication, et permettent ainsi d'assurer les niveaux de rapport signal à bruit requis par les normes de télécommunication en place.

Ces filtres reposent sur l'utilisation de résonateurs à ondes élastiques, qui se divisent en trois grandes familles :
- Les résonateurs à ondes acoustiques de surface (SAW, pour *Surface Acoustic Wave*) utilisent la propagation d'ondes élastiques à la surface d'un substrat piézoélectrique massif. Sur ce type de substrat, des électrodes en forme de peignes interdigités permettent à la fois l'excitation de ces ondes à partir d'un signal électrique, ou réciproquement de générer un courant à l'image d'ondes parvenant au niveau des électrodes. En réalisant des structures réflectrices, on parvient à réaliser des cavités résonantes pour ces ondes de surface, et ainsi à présenter une résonance électrique ;
- Les résonateurs à ondes de volume (BAW, pour *Bulk Acoustic Wave*) utilisent quant à eux la propagation d'ondes élastiques dans l'épaisseur d'une couche de matériau piézoélectrique. Une résonance mécanique est obtenue lorsque l'épaisseur de la structure est de l'ordre d'une demi-longueur d'onde, ou d'un multiple de cette épaisseur. Ainsi, afin d'atteindre les fréquences exploitées par la téléphonie sans fil, ces couches doivent présenter des épaisseurs de l'ordre de 1 µm : on parle alors de couches minces. La formation d'une cavité résonante se fait en plaçant une lame d'air sous la couche piézoélectrique, ou en utilisant un miroir acoustique venant isoler la couche piézoélectrique du substrat servant de support à la structure. Comme pour les résonateurs SAW, la résonance mécanique de la structure se traduit par une résonance électrique, étant donné l'utilisation de matériaux piézoélectriques.

Enfin, un troisième type de composants est à l'étude dans le monde académique : il s'agit de résonateurs à modes de plaques (ou à ondes de Lamb, ou à modes de contour, ...). Dans ce type de résonateurs, on exploite la propagation d'ondes guidées latéralement dans une couche piézoélectrique. A l'instar des composants SAW, ces ondes sont excitées et détectées par des électrodes en forme de peignes interdigités. A l'instar des composants BAW, le confinement des ondes nécessite une isolation de la couche mince piézoélectrique faisant office de guide d'onde par l'insertion d'une lame d'air ou d'un miroir acoustique entre substrat et couche piézoélectrique.

Quel que soit le type de résonateur considéré, la réponse électrique du composant est décrite, au premier ordre, par le schéma équivalent dit de Butterworth-Van Dyke (BVD), qui consiste en une capacité (représentant la disposition d'électrodes autour du matériau piézoélectrique isolant) connectée en parallèle avec un résonateur électrique R-L-C série (représentant la transposition dans le domaine électrique de la résonance mécanique de la structure). La réponse électrique de ce type de composant est donc avant tout celle d'une capacité, mais à laquelle se superpose une résonance électrique. Lorsque cette résonance survient, l'impédance du résonateur devient très faible, et ce dernier sera donc capable d'assurer une transmission d'un signal électrique avec un minimum de pertes. A une fréquence légèrement supérieure à la fréquence de résonance se produit un effet de couplage entre la capacité statique du résonateur et la branche résonante, qui se traduit par une augmentation de l'impédance du résonateur. Ce dernier, à cette fréquence, devient capable de bloquer la transmission d'un signal électrique.

On utilise cette capacité d'un résonateur à être passant à une fréquence et bloquant à une autre afin de réaliser un circuit passe-bande. Le principe de ces architectures a été théorisé dès les années 1930. Il consiste à disposer des résonateurs dits « série » sur le chemin du signal électrique, et d'autres résonateurs dits « parallèle » entre le chemin du signal électrique et la masse du circuit. Ces deux jeux de résonateurs sont décalés en fréquence, de manière à ce que la résonance des résonateurs série coïncide avec l'antirésonance des résonateurs parallèle. Ceci assure la transmission du signal de l'entrée vers la sortie du circuit, à cette fréquence, appelée fréquence centrale. A la fréquence de résonance des résonateurs parallèle, ces derniers viennent court-circuiter le composant, et bloquent toute transmission du signal, rendant le filtre bloquant.A la fréquence d'antirésonance des résonateurs série, ces derniers se comportent comme des circuits ouverts, et empêchent donc le passage du signal. Ainsi donc le circuit est-il passant autour de la fréquence centrale, et bloquant ailleurs en fréquence. La largeur de la bande passante du filtre est par conséquence fonction de l'espacement relatif entre les fréquences de résonance et d'antirésonance des résonateurs qui le compose. Or cet écart est quantifié par un coefficient dit de couplage électromécanique (k²), qui par ailleurs quantifie la fraction d'énergie pouvant être convertie du domaine électrique au domaine mécanique, ou vice-versa, au sein d'un résonateur à chaque période d'oscillation. Ce coefficient dépend directement de la géométrie du résonateur, du type d'onde exploité, mais également des propriétés piézoélectriques du matériau employé.

L'augmentation des débits de transmission de données a entraîné des besoins plus grands en termes de bande passante. Les filtres passe-bande doivent donc être basés sur des résonateurs acoustiques possédant des coefficients de couplage électromécaniques de plus en plus élevés.

Historiquement, des bandes passantes de l'ordre de 2 à 3 % de largeur relative nécessitaient des résonateurs possédant des coefficients de couplage électromécaniques de l'ordre de 5 à 6 %. A présent, ces bandes tendent vers des largeurs relatives de l'ordre de 4 %, nécessitant des coefficients de couplage approchant les 8 %. L'ouverture de bandes de fréquence à plus haute fréquence permet de relâcher les besoins en termes de bandes passantes relatives. Néanmoins, les structures résonantes ne peuvent pas être exactement mises à l'échelle pour suivre la montée en fréquence, ce qui entraîne des conditions défavorables au développement de forts coefficients de couplage électromécaniques. De manière similaire, la multiplication des bandes de fréquences entraine un encombrement du spectre radio, ce qui conduit à une réduction des marges fréquentielles disponibles entre les différentes bandes. Ceci entraîne le besoin de filtres présentant des réjections élevées en bord de bande passante, mais également des dispersions fréquentielles (dues aux tolérances de fabrication et aux dérives liées aux sensibilités environnementales) réduites. La réponse des fabricants de filtres à cet état de fait a été l'introduction de structures de résonateurs compensées en température afin de présenter des dérives de la fréquence en fonction de la température amoindries, voire même annulées.Ces structures nécessitent toutefois l'ajout de couches de matériaux assurant une compensation des effets de température à l'intérieur de la structure résonante, ce qui s'accompagne parfois d'une diminution des coefficients de couplage électromécanique. Le seul moyen dans ces conditions de maintenir ces coefficients de couplage à un niveau acceptable consiste à se tourner vers des matériaux possédant des propriétés piézoélectriques améliorées.

Enfin, ces dernières années ont vu l'émergence de concepts de résonateurs agiles en fréquence, c'est-à-dire possédant des fréquences de résonance pilotable électriquement. L'obtention d'une agilité effective se fait toutefois en troquant une partie du coefficient de couplage électromécanique d'origine du résonateur contre une plage de variation relative de fréquence. Ainsi donc, là aussi, des matériaux possédant des propriétés piézoélectriques améliorées sont-ils nécessaires.

Les composants à ondes de surface sont généralement réalisés à partir de substrats monocristallins de matériaux piézoélectriques tels que le tantalate ou de niobate de lithium (LiTaO₃ ou LiNbO₃), le quartz (SiO₂), le niobate de potassium (KNbO₃), la langasite (La₃Ga₅SiO₁₄), la langalate (La₃Ga_{5.5}Ta_{0.5}O₁₄). Des orientations cristallines privilégiées ont été déterminées pour ces matériaux afin de présenter, pour les ondes de surface, des coefficients de couplage électromécaniques compatibles avec les besoins en termes de synthèse de filtre (de 4 à 7 %), tout en tentant de maintenir les dérives de la fréquence en température à des niveaux acceptables (de l'ordre de 40 ppm/K). En ce qui concerne les composants à ondes de volume ou de plaque, ces derniers ont principalement été développés en utilisant le nitrure d'aluminium (AIN) comme matériau piézoélectrique. Les techniques de dépôt de couches minces de ce matériau sont en effet à présent bien établies, et permettent d'atteindre des coefficients de couplage électromécanique pour les ondes de volume entre 6 et 7 % ainsi que des dérives de la fréquence en température, sans compensation, de l'ordre de 30 à 35 ppm/K. Ces dernières années, le développement de solutions solides dérivées de ce matériau, notamment de ScₓAl₁₋ₓN, ont permis d'améliorer les coefficients de couplage électromécaniques jusqu'à 12 % pour des concentrations en Scandium de l'ordre de 15 %, sans nécessiter de modification majeure des technologies existantes (Moreira, Aluminum scandium nitride thin-film bulk acoustic resonators for wide band applications, Vacuum 86, 23 (2011)).

Néanmoins, ces gains ne sont pas encore suffisants pour permettre le développement de solutions de filtrage agiles en fréquence. C'est pourquoi la recherche se tourne actuellement vers l'utilisation de couches minces de niobate ou de tantalate de lithium pour des applications de filtres à ondes de volume ou à ondes de plaque. En effet, certaines orientations cristallines permettent l'obtention de coefficients de couplage électromécaniques allant jusqu'à 45 %, et permettraient donc en théorie l'atteinte d'agilités en fréquence relatives de l'ordre de 10 à 20 % (A. Reinhardt, Acoustic filters based on thin single crystal LiNbO3 films: status and prospects, Proceedings of the 2014 IEEE International Ultrasonics Symposium, p. 773-781).

Si le niobate de lithium est disponible sous forme de substrats monocristallins de grande qualité, ce matériau est toutefois extrêmement difficile à synthétiser en couches minces. En effet, sa cristallisation nécessite des températures extrêmement élevées (≥ 600°C), tandis que ses coefficients de dilatation très élevées le rendent propice à la génération de contraintes thermoélastiques si élevées que les films peuvent rapidement présenter des fissures ou délaminer.

Par ailleurs, la maîtrise de la stoechiométrie des films et de leur qualité cristalline reste encore problématique. Qui plus est, les orientations cristallines préférentielles pour la génération d'ondes présentant des coefficients de couplage électromécaniques élevés ne correspondent pas à des axes de symétrie principaux, rendant quasi impossible la croissance épitaxiale de films aux propriétés optimales. L'épitaxie de ce matériau est de plus incompatible avec la présence d'électrodes métalliques localisées sous le film, comme cela est nécessaire pour des résonateurs à ondes acoustiques de volume ou certaines formes de résonateurs à ondes de plaques.

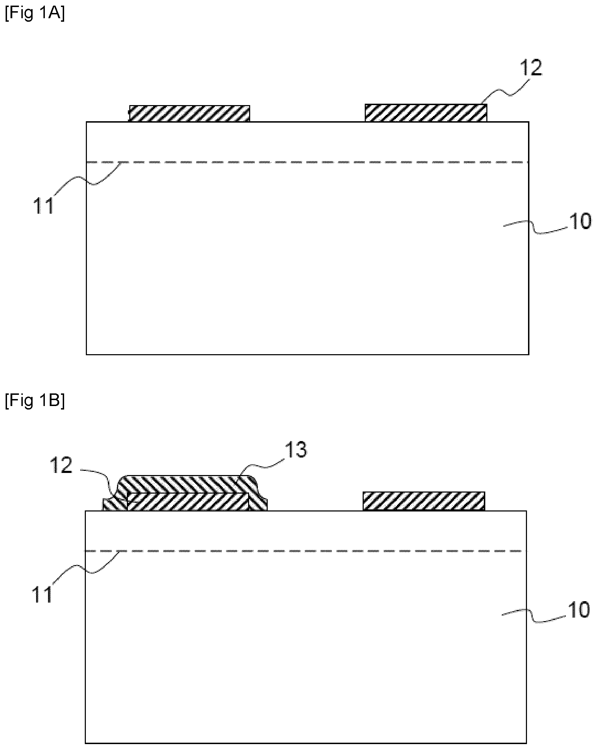

Pour disposer de couches minces de matériaux monocristallins présentant une orientation cristallographique définie, la solution proposée jusqu'à présent a consisté à utiliser des techniques de report de couches minces. La demande du brevet EP2388840 divulgue un procédé de fabrication d'un substrat piézoélectrique composite et la demande du brevet FR2857983 montre un procédé de fabrication d'une couche épitaxiée notamment pour des applications dans les domaines de l'optique, l'optoélectronique ou l'électronique. Le brevet FR 2 953 647 (US 8,431,031 B2) présente un procédé permettant de réaliser un résonateur à ondes de volume selon cette technique, mais peut tout aussi bien être utilisé pour réaliser des résonateurs à ondes de plaques. Un exemple de procédé de réalisation utilisant cette technique est décrit grâce aux figures 1A à 1H.

Etapes 1 et 2, illustrées en figure 1A :
l'implantation d'ions légers dans un substrat de niobate de lithium **10** afin de former une couche présentant des défauts cristallins **11** ;
le dépôt de métal, par exemple d'AlSi par pulvérisation, puis photolithographie, gravure humide et retrait de résine, afin de former un jeu d'électrodes inférieures **12** ;

Etape 3 illustrée en figure 1B :
le dépôt et structuration d'une couche active **13** sacrifiée afin de former un caisson de libération localisé sous la zone active de chaque résonateur ;

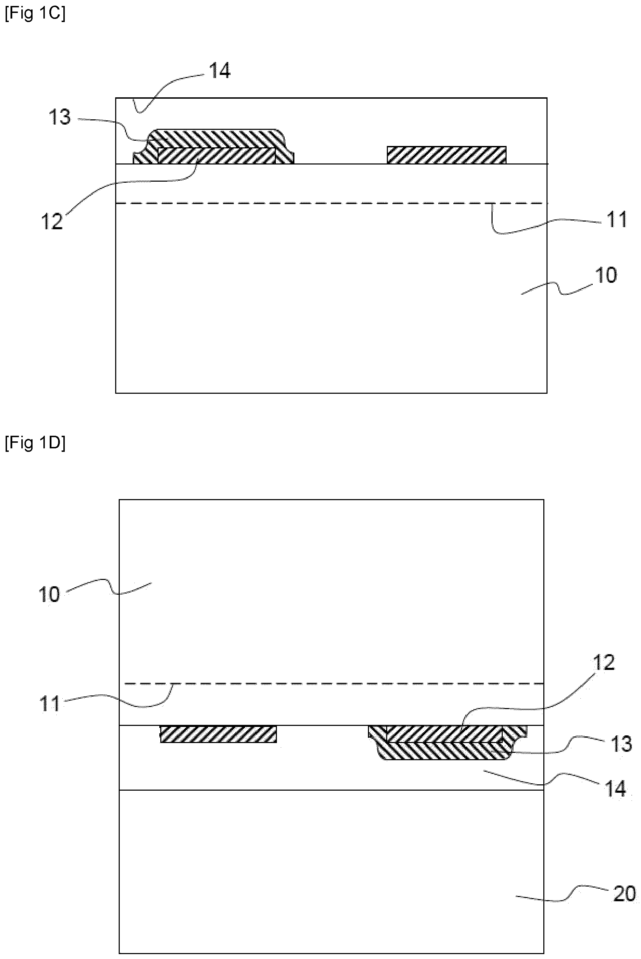

Etape 4 illustrée en figure 1C :
le dépôt d'une couche de collage **14** puis planarisation par polissage mécano-chimique afin de présenter une surface plane compatible avec un collage direct ;

Etapes 5, 6 et 7 illustrées en figure 1D :
sur un second substrat, dit receveur **20,** on procède au dépôt d'une couche de collage ;
on procède au collage du substrat donneur **10** sur le substrat receveur **20** par collage direct ;
on procède à une étape de recuit de consolidation du collage.

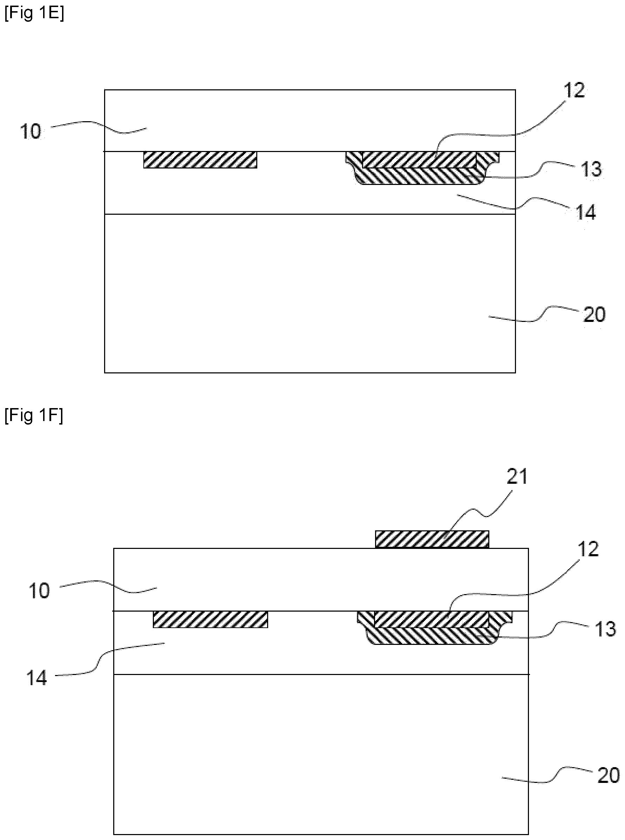

Etapes 8 et 9 illustrées en figure 1E :
on réalise une opération de traitement thermique visant à une maturation des défauts d'implantation dans le substrat **10,** jusqu'à la fracturation (splitting en anglais) de ce dernier ;
on procède à une opération de polissage mécano-chimique pour supprimer la rugosité post-fracture et ajustement de l'épaisseur finale de la couche piézoélectrique reportée.

Etape 10 illustrée en figure 1F :
on procède au dépôt et à la structuration des électrodes supérieures **21** ;

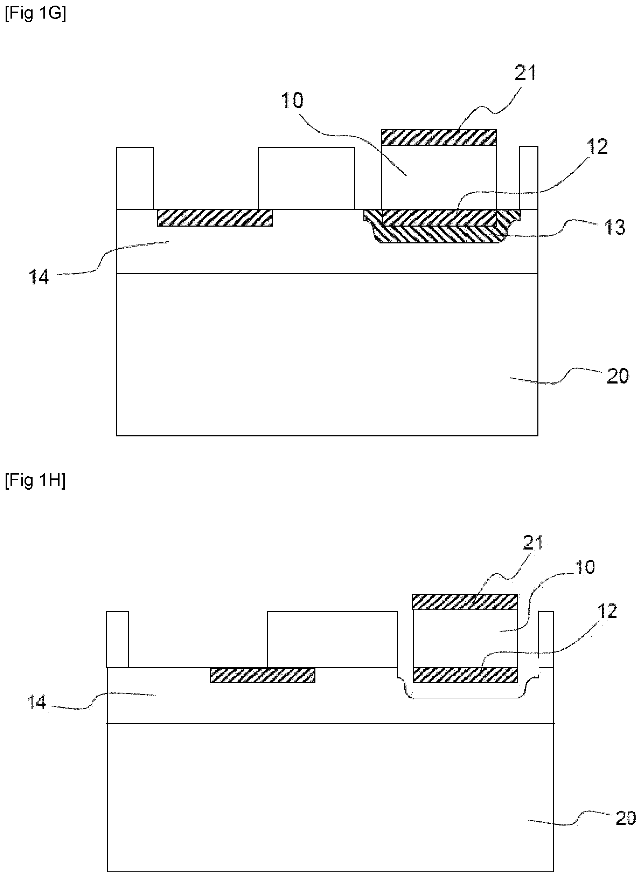

Etape 11 illustrée en figure 1G :
on réalise des opérations de photolithographie, gravure par faisceau d'ion et retrait de résine pour former des ouvertures à travers le film reporté **10** permettant une reprise de contact électrique sur l'électrode inférieure **12** ou des accès à la couche sacrifiée **13.**

Etape 12 illustrée en figure 1H :
on procède à la libération de la structure de résonateur par gravure chimique du silicium par XeF₂ gazeux.

Ce procédé de fabrication permet l'obtention de composants fonctionnels. Néanmoins, l'implantation d'espèces gazeuses dans le cristal, en vue de permettre une fracture de celui-ci, génère nombre de défauts dans la structure cristalline. Après la fracture (étape 8), une partie des ions implantés reste présente dans le cristal où elle provoque des contraintes localisées, et perturbe l'ordre cristallin, entraînant une diminution des propriétés piézoélectriques macroscopiques de la couche. Une partie de ces défauts résiduels est supprimée lors de l'étape de polissage mécano-chimique 9), mais ceci est loin d'être suffisant. Il convient donc d'appliquer des traitements de guérison dans le volume de la couche, tel qu'un traitement thermique à la couche reportée pour éliminer les défauts résiduels d'implantation/fracture (notamment par exodiffusion des espèces gazeuses). Ces traitements doivent nécessairement porter l'échantillon à une température supérieure à la température de fracture, c'est-à-dire à plus de 300°C, mais rester bien inférieurs à la température de Curie du matériau (soit approximativement 1140°C pour le LiNbO₃, 602°C pour le LiTaO₃) afin de ne pas provoquer de changement de phase (ferroélectrique -> paraélectrique) qui viendrait désorienter les domaines ferroélectriques établis dans le cristal, et ainsi supprimer toute piézoélectricité macroscopique. Notons qu'une étape de polarisation (*poling* en anglais) qui consiste à appliquer un champ électrique supérieur au champ coercitif (E_{c} = 180 kV/cm pour le LiNbO₃, 160 kV/cm pour le LiTaO₃) est alors requise afin de réorienter les domaines ferroélectriques et donc obtenir un caractère piézoélectrique macroscopique.

Le Demandeur a étudié l'influence de recuits à 350°C et à 400°C, tous deux réalisés pendant 2 heures. Cette étude révèle la présence de défauts en forme de bulles et s'étendant sur une profondeur de plus de 100 nm dans le cas d'un recuit à 350°C, et de 50 nm dans le cas d'un recuit à 400°C. Clairement, un recuit à 400°C pendant 2 heures n'est pas suffisant pour éliminer les défauts résiduels d'implantation, permettant ainsi la guérison du matériau piézoélectrique. Une température plus élevée et/ou un temps de recuit supérieur devrait être appliqué.

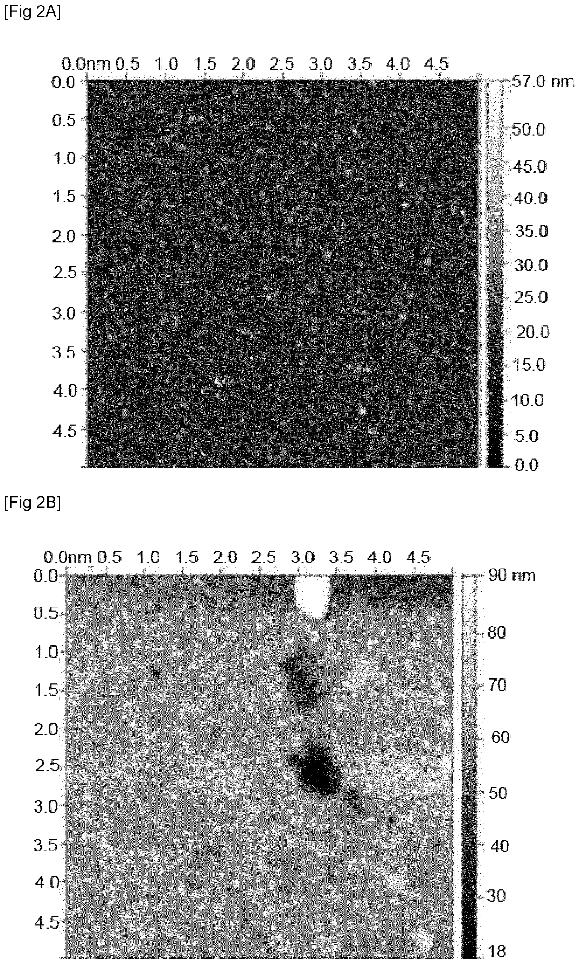

Il faut toutefois remarquer que dans le procédé de réalisation présenté ci-dessus, le recuit de guérison des défauts d'implantation est réalisé alors que l'empilement présente déjà une certaine hétérogénéité. En particulier des électrodes inférieures en aluminium (ou aluminium-silicium ou aluminium-cuivre) sont présentes sous la couche de niobate de lithium reportée. Ce métal présente une température de fusion d'environ 660°C, ainsi qu'un coefficient de dilatation (~13 ppm/°C) supérieur à celui du niobate de lithium selon certaines orientations cristallines. Ces deux conditions entrainent l'apparition de fortes déformations dans le matériau lors de l'application de budgets thermiques élevés, menant à la formation de structures en forme de bosses (*hillocks* en anglais) résultant de phénomènes mécaniques internes au film métallique. De telles bosses, comme par exemple visibles sur les figures 2A et 2B [relatives à des observations par microscopie à force atomique de la surface d'une couche mince d'aluminium déposée sur un substrat de niobate de lithium (figure 2A) après dépôt et (figure 2B) après recuit à 400°C pendant 2 heures] entrainent une augmentation de la rugosité du film et peuvent conduire à de la défectivité électrique lorsque ces bosses grandissent à l'intérieur d'une couche adjacente.

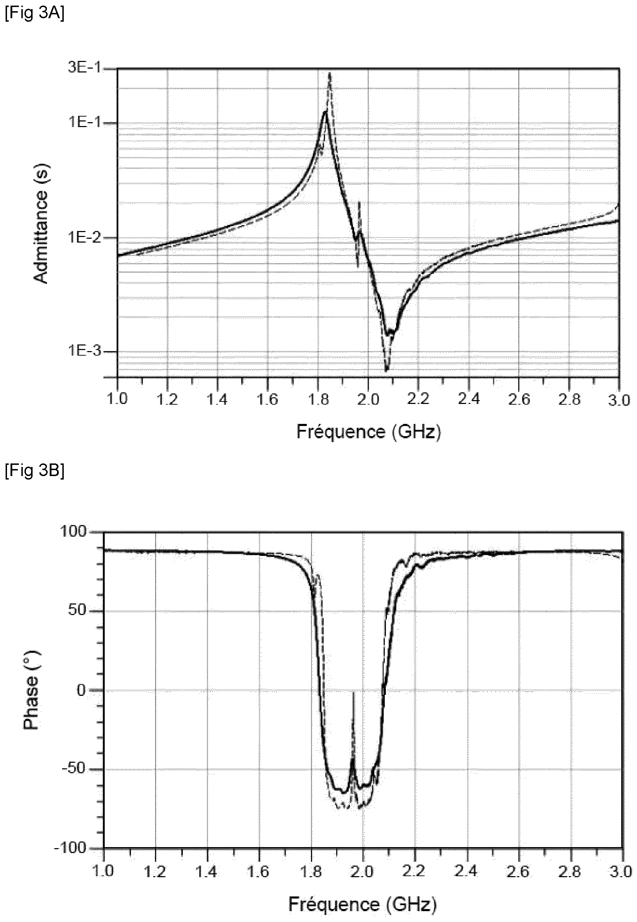

Ce phénomène est fort bien connu dans le monde de la microélectronique. Du point de vue de la réponse électrique du résonateur, l'impact du recuit est visible sur les figures 3A et 3B relatives à l'impact d'un recuit sur la réponse électrique d'un résonateur à ondes de volume en niobate de lithium (3A) module de l'admittance et (3B) phase de l'impédance. Les courbes en pointillés et en trait plein épais correspondent respectivement à un résonateur réalisé à partir d'une couche de niobate de lithium recuite à 350°C et 400°C où un même résonateur réalisé sur deux échantillons différents, l'un recuit à 350°C et l'autre à 400°C, est présenté. On note principalement la dégradation du coefficient de qualité pour l'échantillon dont la couche a été recuite à plus haute température. Ceci est principalement attribué à la dégradation de l'électrode inférieure.

Pour contourner ce problème, il est possible d'envisager l'utilisation d'autres électrodes métalliques. Des matériaux comme le Platine ou le Palladium sont en effet souvent utilisés comme électrodes pour des matériaux piézoélectriques synthétisés à haute température, tel que par exemple le PbZrₓTi₁₋ₓO₃ ou pour des applications de capteurs fonctionnant à haute température (plus de 400°C). Néanmoins ces métaux présentent l'inconvénient de présenter une résistivité élevée et de fortes pertes mécaniques, ce qui dégrade plus encore les coefficients de qualité que la dégradation d'électrodes en aluminium. Par ailleurs, ces matériaux présentent de faibles adhérences sur le niobate de lithium, ou vis-à-vis de l'oxyde de silicium utilisé comme couche de collage, ce qui se traduit par des délaminations. Ceci peut être contourné par l'insertion de couches d'accroche, mais ces dernières peuvent facilement s'oxyder au contact du niobate ou du tantalate de lithium, ce qui se traduit par la formation de capacités d'interface et la formation de lacunes d'oxygène dans le matériau piézoélectrique. Ces deux effets se traduisent respectivement par une diminution des propriétés piézoélectriques du matériau et par des courants de fuite néfastes pour l'application considérée.

De manière générale, tous les matériaux présentant un compromis acceptable entre propriétés mécaniques et électriques se trouvent être sensibles à des recuits à haute température d'une manière ou d'une autre (oxydation, contraintes, recristallisation, ...). Aussi est-il donc nécessaire de modifier le procédé de fabrication de ces résonateurs pour éviter aux couches en présence (métaux, couche sacrifiée) de subir les recuits à haute température nécessaires à la guérison des défauts d'implantation dans le niobate de lithium.

Une autre problématique liée au procédé présenté ci-dessus porte sur la gestion des différences de coefficient de dilatation thermique entre les matériaux en présence. Le niobate de lithium possède en effet des coefficients de dilatation de l'ordre de 5 à 10 fois plus élevés que le silicium. Qui plus est, sa dilatation est anisotrope. Ainsi, lors du recuit de fracture déjà, les déformations de l'empilement composé du substrat donneur et du substrat receveur collés ensemble peuvent devenir extrêmement élevées et conduire soit à des décollements, soit, si l'énergie de collage est suffisamment élevée, à une rupture mécanique de la structure. Pour cette raison, le procédé utilisé actuellement consiste uniquement à reporter un film de niobate de lithium sur un substrat de niobate de lithium (report en homostructure). Une approche consistant à reporter un film de niobate de lithium sur silicium (report en hétérostructure) reste à l'heure actuelle encore délicate à réaliser de manière reproductible. Ceci empêche la réalisation des composants sur des lignes de fabrication dédiées à des substrats silicium, complique le procédé de réalisation, et d'une certaine manière le prive de commodités en matière de d'options technologiques. Il est donc nécessaire de faire évoluer le procédé de réalisation existant afin de permettre un report de couches minces monocristallines sur substrat silicium.

Enfin, dans le procédé actuel, les couches constituant l'électrode inférieure, les caissons de libération et la couche de collage nécessitent des dépôts à basse température, inférieure à la température de fracturation, afin de ne pas provoquer un murissement des défauts d'implantation, qui pourrait se traduire par une exfoliation de la surface due à une fracture prématurée du substrat donneur. En pratique, les dépôts réalisés avant l'étape de fracture sont limités à une température d'approximativement 150°C. Ceci limite le choix des procédés de réalisation utilisables, et dans une certaine mesure la qualité des matériaux employés. Par exemple, les électrodes utilisées ne sont pas ou peu cristallisées et texturées, ce qui peut se traduire par une tenue en puissance limitée pour les composants. Un second problème potentiel réside dans le dépôt de couches d'oxyde de silicium insuffisamment denses, qui peuvent donc absorber de l'humidité ou contenir encore des gaz issus du procédé de dépôt (Ar principalement). Lors des recuits de guérison à haute température, ces gaz piégés peuvent potentiellement provoquer l'apparition de bulles, voire percer l'empilement afin de permettre au gaz de s'échapper. Enfin, dans le cas où l'on voudrait ajouter une couche de passivation afin de protéger le composant de l'environnement extérieur, cette dernière risque de ne pas être suffisamment dense pour assurer son rôle de barrière à l'oxygène et/ou à l'humidité ambiante. La fiabilité des composants est donc pour l'heure encore limitée. Il convient donc également de modifier le procédé de fabrication afin de ne plus subir une limitation en termes de budget thermique pour les dépôts des premières couches de l'empilement.

C'est pourquoi, la présente invention a pour objet un procédé de fabrication d'un composant comprenant le report d'un ensemble comportant une ou plusieurs couche(s) de matériau(x) monocristallin(s) piézoélectrique(s) ou pyroélectrique(s) ou ferroélectrique(s) sur un substrat final, ledit procédé comprenant au moins :
- un premier ensemble d'étapes comportant :
   ∘ une étape d'implantation d'ions dans un substrat donneur de matériau monocristallin piézoélectrique ou pyroélectrique ou ferroélectrique à un niveau d'implantation de manière à définir une zone de couche dans ledit matériau monocristallin piézoélectrique ou pyroélectrique ou ferroélectrique ;
   o une étape de premier assemblage dudit substrat donneur de matériau monocristallin piézoélectrique ou pyroélectrique ou ferroélectrique sur un substrat temporaire, ladite étape de premier assemblage comprenant la réalisation d'une zone d'interface fragile de séparation entre ledit substrat donneur de matériau monocristallin piézoélectrique ou pyroélectrique ou ferroélectrique et ledit substrat temporaire, ladite zone comprenant au moins deux couches de matériaux différents pour assurer la mise en contact de deux composés aptes à générer une interdiffusion d'élément(s) constitutif(s) d'au moins un des deux composés ;
   ∘ une étape d'amincissement dudit substrat donneur de premier matériau monocristallin piézoélectrique ou pyroélectrique ou ferroélectrique jusqu'au niveau d'implantation définissant une couche de matériau monocristallin piézoélectrique ou pyroélectrique ou ferroélectrique ;
   ∘ une étape de guérison des défauts résiduels par recuit thermique de ladite couche de matériau monocristallin piézoélectrique ou pyroélectrique ou ferroélectrique ;
- et un second ensemble d'étapes postérieures au premier ensemble d'étapes comportant au moins :
   ∘ une étape de second assemblage d'un ensemble comprenant la ou les couche(s) de matériau(x) monocristallin(s) piézoélectrique(s) ou pyroélectrique(s) ou ferroélectrique(s) et ledit substrat temporaire, avec un substrat final;
   ∘ une étape de séparation du substrat temporaire de ladite couche de matériau monocristallin piézoélectrique ou pyroélectrique ou ferroélectrique, au niveau de ladite zone d'interface fragile de séparation.

Par « interdifusion d'éléments constitutif(s) d'au moins un des deux composés » on entend une diffusion chimique entre les deux couches de la zone d'interface fragile. Cette diffusion chimique permet l'échange de composés entre ces deux couches ce qui tend à homogénéiser la composition desdites deux couches dans ladite zone d'interface fragile.

Selon des variantes de l'invention, le second ensemble d'étapes comprend une étape de réalisation d'une première structure fonctionnelle sur l'une des couches de matériau monocristallin piézoélectrique ou pyroélectrique ou ferroélectrique.

Selon des variantes de l'invention, le second ensemble d'étapes comprend une étape de réalisation d'une seconde structure fonctionnelle sur l'une des couches de matériau monocristallin piézoélectrique ou pyroélectrique ou ferroélectrique.

Selon des variantes de l'invention, après l'étape d'amincissement dudit substrat donneur d'un premier matériau monocristallin piézoélectrique ou pyroélectrique ou ferroélectrique jusqu'au niveau d'implantation définissant une couche de matériau monocristallin piézoélectrique ou pyroélectrique ou ferroélectrique, ledit procédé comprend la réalisation d'une couche supplémentaire de deuxième matériau monocristallin piézoélectrique ou pyroélectrique ou ferroélectrique à la surface de ladite couche de matériau monocristallin piézoélectrique ou pyroélectrique ou ferroélectrique, lesdits premier et deuxième matériaux pouvant être identiques ou différents.

Selon des variantes de l'invention, l'épaisseur de la couche de premier matériau est inférieure ou égale à 1 micron, l'épaisseur de la couche supplémentaire de second matériau est supérieure à plusieurs microns.

Selon des variantes de l'invention, la réalisation de ladite zone d'interface fragile de séparation entre ledit substrat donneur de matériau monocristallin piézoélectrique ou pyroélectrique ou ferroélectrique et ledit substrat temporaire comprend au moins :
- la réalisation d'une couche d'oxyde ou de nitrure ;
- le dépôt d'une couche de métal noble ;
- une opération de recuit thermique apte à créer ladite interdiffusion d'élément(s) constitutif(s) d'au moins un des deux composés.

Selon des variantes de l'invention, le procédé comprend :
- la réalisation d'une couche d'oxyde de silicium ou de nitrure de silicium ;
- le dépôt d'une couche de métal noble de Pt ou de Au ou de Rh ou de Os ou de Pd ou de Ru ou de Ir.

Selon des variantes de l'invention, l'étape de guérison des défauts résiduels par recuit thermique est réalisée avec un budget thermique apte à provoquer la diffusion du métal noble dans l'oxyde ou dans le nitrure, ledit budget thermique pouvant être réalisé à une température comprise entre 300°C et 700°C pendant une durée comprise entre 1 heure et 10 heures.

Selon des variantes de l'invention, l'étape de premier assemblage dudit substrat de matériau monocristallin piézoélectrique ou pyroélectrique ou ferroélectrique sur un substrat temporaire, est réalisé avec une première couche de collage en matériau constituant l'un des matériaux pour assurer la mise en contact de deux composés aptes à générer une interdiffusion d'élément(s) constitutif(s) d'au moins un des deux composés.

Selon des variantes de l'invention, l'étape de premier assemblage dudit substrat de matériau monocristallin piézoélectrique ou pyroélectrique ou ferroélectrique sur un substrat temporaire, est réalisé avec une première couche de collage pouvant être une couche d'oxyde de silicium (SiO₂), une couche métallique (Cu, Au, Ti, Ag, ...) ou de polymère tel que le benzocyclobutène BCB.

Selon des variantes de l'invention, l'étape de second assemblage d'un ensemble comprenant la ou les couche(s) de matériau(x) monocristallin(s) piézoélectrique(s) ou pyroélectrique(s) ou ferroélectrique(s) et ledit substrat temporaire, avec un substrat final est réalisé avec au moins une seconde couche de collage pouvant être minérale et pouvant être en SiO₂ ou SiOₓN_{y}.

Selon des variantes de l'invention, l'étape de séparation du substrat temporaire est réalisée mécaniquement au niveau de l'interface fragile.

Selon des variantes de l'invention, le substrat donneur de matériau monocristallin piézoélectrique ou pyroélectrique ou ferroélectrique est en niobate de lithium, ou tantalate de lithium.

Selon des variantes de l'invention, le substrat temporaire est de même nature que le substrat donneur de matériau monocristallin piézoélectrique ou pyroélectrique ou ferroélectrique.

Selon des variantes de l'invention, le substrat final est en matériau de type niobate de lithium, tantalate de lithium ou silicium ou verre ou saphir.

Selon des variantes de l'invention, le procédé de fabrication comporte :
- la réalisation d'une première structure fonctionnelle métallique sur une première face de ladite couche de matériau monocristallin piézoélectrique ou pyroélectrique ou ferroélectrique, configurée pour être une électrode continue ou une série d'électrodes discontinues ;
- la réalisation d'une seconde structure fonctionnelle métallique sur la face opposée de ladite couche de matériau monocristallin piézoélectrique ou pyroélectrique ou ferroélectrique ou sur une face opposée d'une autre couche de matériau monocristallin piézoélectrique ou pyroélectrique ou ferroélectrique, configurée pour être une électrode continue ou une série d'électrodes discontinues, ladite première face correspondant à la face amincie du substrat donneur de matériau monocristallin piézoélectrique ou pyroélectrique.

Selon des variantes de l'invention, le composant étant un résonateur à ondes acoustiques, ledit procédé comprend :
- le dépôt d'une couche sacrificiée à la surface d'une couche de matériau monocristallin piézoélectrique ou pyroélectrique ou ferroélectrique ou à la surface de la couche supplémentaire de deuxième matériau monocristallin piézoélectrique ou pyroélectrique ou ferroélectrique et/ou à la surface de la première structure fonctionnelle métallique, ladite couche sacrifiée pouvant être en silicium amorphe ;
- la réalisation d'au moins un caisson dans ladite couche sacrifiée ;
- une opération de gravure dudit caisson de manière à réaliser une membrane suspendue de matériau monocristallin piézoélectrique ou pyroélectrique ou ferroélectrique.

Selon des variantes de l'invention, le composant étant un résonateur à ondes acoustiques, ledit procédé comprend la réalisation de cavités dans ledit substrat final avant l'opération de second assemblage.

Selon des variantes de l'invention, le composant étant un résonateur à ondes acoustiques, ledit procédé comprend la réalisation d'un empilement avec alternativement des couches présentant des impédances acoustiques faibles et des couches présentant des impédances acoustiques élevées (par exemple, SiO₂/W, ou SiO₂/Mo, ou SiO₂/AlN ou SiOC/SiN, ...) à la surface de la couche de matériau monocristallin piézoélectrique ou pyroélectrique ou ferroélectrique ou à la surface de la couche supplémentaire de second matériau piézoélectrique ou pyroélectrique ou ferroélectrique, pour réaliser une structure de miroirs de Bragg.

Selon des variantes de l'invention, le composant comportant un ensemble d'au moins deux résonateurs à ondes élastiques de volume empilés, le procédé comprend :
o la fabrication d'un résonateur comprenant au moins une première couche de matériau monocristallin piézoélectrique ou pyroélectrique ou ferroélectrique, une première structure fonctionnelle métallique, une seconde structure fonctionnelle métallique sur un substrat final ;
o le dépôt d'une ou de plusieurs couche(s) d'isolation ou de couplage acoustique à la surface dudit premier résonateur ;
o la réalisation d'une première structure fonctionnelle métallique apte à former une première électrode d'un second résonateur à la surface de ladite ou d'une desdites couche(s) d'isolation acoustique ou de couplage acoustique;
o le report d'une seconde couche de matériau monocristallin piézoélectrique ou pyroélectrique ou ferroélectrique reporté sur un substrat temporaire via une zone d'interface fragile de séparation à la surface dudit substrat temporaire ;
o le retrait dudit substrat temporaire de manière à laisser libre une seconde face de ladite seconde couche active ;
o la réalisation d'une seconde structure fonctionnelle métallique, de manière à définir le second résonateur.

Selon des variantes de l'invention, le composant étant un capteur pyroélectrique comprenant une couche active comprise entre deux électrodes continues , la couche de matériau monocristallin piézoélectrique ou pyroélectrique ou ferroélectrique pouvant être en tantalate de lithium, le procédé comprend en outre la gravure partielle en face arrière du substrat final de manière à définir une membrane dans ledit substrat final, ledit substrat final pouvant être en silicium.

Selon des variantes de réalisation, la zone d'interface fragile comprend une couche de métal noble et une autre couche comprenant au moins l'un des matériaux suivants :
- un oxyde ;
- un nitrure ;
- un oxynitrure de silicium ;
- un oxycarbure de silicium SiOC ;
- un fluor SiOF.

Par « métal noble », on entend un métal qui résiste à la corrosion et à l'oxydation. De tels métaux sont par exemple : l'or, l'argent, le platine, le palladium, l'iridium, le rhodium, l'osmium, le ruthénium, le cuivre, le rhénium, le mercure, les aciers inoxydables, le titane, le zirconium, le tantale.

D'autres caractéristiques et avantages de l'invention apparaîtront à l'aide de la description qui suit, faite en regard de dessins annexés qui représentent :
[FIG.1A] illustre une étape d'un procédé selon l'art antérieur ;
[FIG.1B] illustre une étape d'un procédé selon l'art antérieur ;
[FIG.1C] illustre une étape d'un procédé selon l'art antérieur ;
[FIG.1D] illustre une étape d'un procédé selon l'art antérieur ;
[FIG.1E] illustre une étape d'un procédé selon l'art antérieur ;
[FIG.1F] illustre une étape d'un procédé selon l'art antérieur ;
[FIG.1G] illustre une étape d'un procédé selon l'art antérieur ;
[FIG.1H] illustre une étape d'un procédé selon l'art antérieur ;
[FIG.2A] illustre les observations par microscopie à force atomique de la surface d'une couche mince d'aluminium déposée sur un substrat de niobate de lithium après dépôt;
[FIG.2B] illustre les observations par microscopie à force atomique de la surface d'une couche mince d'aluminium déposée sur un substrat de niobate de lithium après recuit à 400°C pendant 2 heures ;
[FIG.3A] illustre l'impact d'un recuit sur la réponse électrique d'un résonateur à ondes de volume en niobate de lithium (module de l'admittance);
[FIG.3B] illustre l'impact d'un recuit sur la réponse électrique d'un résonateur à ondes de volume en niobate de lithium (phase de l'impédance). Les courbes pointillée et continue en trait épais correspondent respectivement à un résonateur réalisé à partir d'une couche de niobate de lithium recuite à 350°C et 400°C ;
[FIG.4A] illustre une étape d'une première variante de procédé selon l'invention;
[FIG.4B] illustre une étape d'une première variante de procédé selon l'invention;
[FIG.4C] illustre une étape d'une première variante de procédé selon l'invention;
[FIG.4D] illustre une étape d'une première variante de procédé selon l'invention;
[FIG.4E] illustre une étape d'une première variante de procédé selon l'invention;
[FIG.4F] illustre une étape d'une première variante de procédé selon l'invention;
[FIG.4G] illustre une étape d'une première variante de procédé selon l'invention;
[FIG.4H] illustre une étape d'une première variante de procédé selon l'invention;
[FIG.4I] illustre une étape d'une première variante de procédé selon l'invention;
[FIG.4J] illustre une étape d'une première variante de procédé selon l'invention;
[FIG.4K] illustre une étape d'une première variante de procédé selon l'invention;
[FIG.4L] illustre une étape d'une première variante de procédé selon l'invention;
[FIG.4M] illustre une étape d'une première variante de procédé selon l'invention;
[FIG.4N] illustre une étape d'une première variante de procédé selon l'invention;
[FIG.4O] illustre une étape d'une première variante de procédé selon l'invention;
[FIG.4P] illustre une étape d'une première variante de procédé selon l'invention;
[FIG.5A] illustre une étape d'une deuxième variante de procédé selon l'invention;
[FIG.5B] illustre une étape d'une deuxième variante de procédé selon l'invention;
[FIG.5C] illustre une étape d'une deuxième variante de procédé selon l'invention;
[FIG.5D] illustre une étape d'une deuxième variante de procédé selon l'invention;
[FIG.5E] illustre une étape d'une deuxième variante de procédé selon l'invention;
[FIG.5F] illustre une étape d'une deuxième variante de procédé selon l'invention;
[FIG.5G] illustre une étape d'une deuxième variante de procédé selon l'invention;
[FIG.6A] illustre une étape d'une troisième variante de procédé selon l'invention;
[FIG.6B] illustre une étape d'une troisième variante de procédé selon l'invention;
[FIG.6C] illustre une étape d'une troisième variante de procédé selon l'invention;
[FIG.6D] illustre une étape d'une troisième variante de procédé selon l'invention;
[FIG.7A] illustre une étape d'une sixième variante de procédé selon l'invention;
[FIG.7B] illustre une étape d'une sixième variante de procédé selon l'invention;
[FIG.7C] illustre une étape d'une sixième variante de procédé selon l'invention;
[FIG.7D] illustre une étape d'une sixième variante de procédé selon l'invention;
[FIG.7E] illustre une étape d'une sixième variante de procédé selon l'invention;
[FIG.7F] illustre une étape d'une quatrième variante de procédé selon l'invention;
[FIG.7G] illustre une étape d'une sixième variante de procédé selon l'invention;
[FIG.7H] illustre une étape d'une sixième variante de procédé selon l'invention;
[FIG.7I] illustre une étape d'une sixième variante de procédé selon l'invention;
[FIG.7J] illustre une étape d'une sixième variante de procédé selon l'invention;
[FIG.7K] illustre une étape d'une sixième variante de procédé selon l'invention;
[FIG.7L] illustre une étape d'une sixième variante de procédé selon l'invention;
[FIG.7M] illustre une étape d'une sixième variante de procédé selon l'invention;
[FIG.7N] illustre une étape d'une sixième variante de procédé selon l'invention;
[FIG.8A] illustre une étape d'une septième variante de procédé selon l'invention;
[FIG.8B] illustre une étape d'une septième variante de procédé selon l'invention;
[FIG.8C] illustre une étape d'une septième variante de procédé selon l'invention;
[FIG.8D] illustre une étape d'une septième variante de procédé selon l'invention;
[FIG.8E] illustre une étape d'une septième variante de procédé selon l'invention;
[FIG.8F] illustre une étape d'une septième variante de procédé selon l'invention;
[FIG.8G] illustre une étape d'une septième variante de procédé selon l'invention;
[FIG.8H] illustre une étape d'une septième variante de procédé selon l'invention;
[FIG.8I] illustre une étape d'une septième variante de procédé selon l'invention;
[FIG.8J] illustre une étape d'une septième variante de procédé selon l'invention;
[FIG.8K] illustre une étape d'une septième variante de procédé selon l'invention;
[FIG.8L] illustre une étape d'une septième variante de procédé selon l'invention;
[FIG.8M] illustre une étape d'une septième variante de procédé selon l'invention;
[FIG.8N] illustre une étape d'une septième variante de procédé selon l'invention;
[FIG.8O] illustre une étape d'une septième variante de procédé selon l'invention;
[FIG.8P] illustre une étape d'une septième variante de procédé selon l'invention;
[FIG.8Q] illustre une étape d'une septième variante de procédé selon l'invention;
[FIG.8R] illustre une étape d'une septième variante de procédé selon l'invention;
[FIG.8S] illustre une étape d'une septième variante de procédé selon l'invention;
[FIG.9A] illustre une étape d'une huitième variante de procédé selon l'invention;
[FIG.9B] illustre une étape d'une huitième variante de procédé selon l'invention;
[FIG.9C] illustre une étape d'une cinquième variante de procédé selon l'invention;
[FIG.9D] illustre une étape d'une huitième variante de procédé selon l'invention.
[FIG.9E] illustre une étape d'une huitième variante de procédé selon l'invention;
[FIG.9F] illustre une étape d'une huitième variante de procédé selon l'invention;
[FIG.9G] illustre une étape d'une huitième variante de procédé selon l'invention;
[FIG.9H] illustre une étape d'une huitième variante de procédé selon l'invention;
[FIG.9I] illustre une étape d'une huitième variante de procédé selon l'invention;
[FIG.9J] illustre une étape d'une huitième variante de procédé selon l'invention;
[FIG.9K] illustre une étape d'une huitième variante de procédé selon l'invention.

De manière générale, pour pallier les problématiques présentées en préambule, le Demandeur propose de séparer les problématiques et de construire séquentiellement le composant final en utilisant un procédé de report original. Ainsi le procédé de fabrication du composant peut comprendre notamment l'ensemble des étapes suivantes :
Etape 1 : la création d'une zone fragilisée par implantation ionique dans un matériau piézoélectrique ou pyroélectrique ou ferroélectrique que l'on souhaite transférer, le dépôt d'une couche de collage qui peut être une couche d'oxyde de silicium (SiO₂) et l'activation du collage via un traitement de polissage mécano-chimique (CMP) et/ou une activation plasma. Une rugosité de moyenne quadratique (RMS) inférieure à 5 Å est préférée. Cette couche de collage peut également être déposée et planarisée avant implantation ionique.
Etape 2 : le report de la couche piézoélectrique ou pyroélectrique ou ferroélectrique sur un substrat temporaire, comportant la réalisation d'une zone d'interface fragile de séparation permettant de détacher ultérieurement cette couche piézoélectrique ou pyroélectrique ou ferroélectrique d'un substrat temporaire. Cette zone d'interface fragile de séparation peut avantageusement être constituée d'un empilement d'au moins deux matériaux qui, mis en contact, engendrent naturellement une faible force d'adhérence à cette interface.
Etape 3: la guérison des défauts provoqués par la fracture et l'implantation ionique. Ceci passe par une étape de polissage et un recuit (ou un recuit suivi d'une étape de polissage). A ce stade, le moyen de détachage du film reporté doit être capable de supporter le budget thermique appliqué.
Etape 4: la réalisation des niveaux inférieurs (électrode inférieure, caissons de couche sacrifiée, le cas échéant, couche de compensation en température et couche de passivation, voire même l'ajout de surmétallisations inférieures...).
Etape 5 : le dépôt d'une couche de collage, et planarisation de celle-ci.
Etape 6: le collage de cet empilement sur le substrat hôte définitif.
Etape 7: la séparation du substrat temporaire via la zone d'interface fragile de de séparation.
Etape 8: le retrait d'éventuelles couches incorporées au substrat temporaire.
Etape 9: la poursuite du procédé de réalisation par ajout des niveaux supérieurs (gravure d'ouvertures dans le film reporté, électrodes supérieures, couche de compensation en température, couche de passivation, surmétallisations, ...).

Procéder de cette manière permet d'appliquer un fort budget thermique au substrat temporaire sans dégrader des couches fonctionnelles en présence et ainsi de s'assurer d'un empilement intègre. Par ailleurs, les étapes suivantes peuvent être effectuées jusqu'à des températures égales à celles du recuit de guérison. On supprime la limitation en budget thermique liée à la présence de défauts d'implantation risquant de provoquer des exfoliations prématurées, ce qui permet d'accéder à des couches minces beaucoup plus denses et de qualité acoustique bien meilleure.

La présente invention s'appuie sur des techniques connues de l'état de l'art : par exemple l'ensemble de techniques présentées dans le brevet FR 2 816 445, qui présente déjà des techniques de report de couches monocristallines utilisant une fracture sur un substrat temporaire, puis le report de la couche reportée sur un substrat hôte définitif. Néanmoins, la présente invention s'en démarque dans le fait que le Demandeur propose d'adjoindre à ces techniques, une zone d'interface fragile de séparation.

Le brevet US 2011/0278993A1 présente également un procédé relativement proche de celui objet de la présente invention : il décrit la réalisation de composants à ondes acoustiques de surface ou de volume composés d'un film piézoélectrique monocristallin reporté a priori selon l'enchainement d'étapes 1-9 décrites précédemment. A l'étape 2 décrite précédemment, ce brevet propose d'insérer une couche diélectrique entre la couche reportée et un substrat fait d'un matériau induisant une contrainte thermique à l'interface substrat temporaire/piézoélectrique inférieure à celle entre le substrat support et le film mince piézoélectrique. Après réalisation des différents niveaux de lithographie et intégration de la couche mince piézoélectrique (étapes 3-6) décrites précédemment, le substrat temporaire est retiré par une gravure (physique ou chimique) sélective de la couche (ex : ZnO, SiO₂, AlN, Cu, Al, Ti ou polyimide) localisée entre le film mince piézoélectrique et le substrat temporaire. Bien que l'épaisseur de cette couche sacrificielle ne soit pas mentionnée, on peut penser que celle-ci est retirée par infiltration chimique et/ou le rodage mécanique du substrat temporaire. Ces deux techniques peuvent rapidement s'avérer prohibitives en termes de durée de traitement et/ou de coût de fabrication.

Le procédé objet de la présente invention se distingue de l'enseignement du brevet US 2011/0278993A1 en proposant avantageusement de former dans l'empilement une zone d'interface fragile de séparation localisée entre le film piézoélectrique ou pyroélectrique ou ferroélectrique et le substrat temporaire, soit le substrat support de départ.

Il devient ainsi possible de défaire cette interface par des moyens mécaniques (insertion de lame par exemple) sans consommation du substrat de départ.

Un avantage majeur de la présente invention réside dans le fait de pouvoir récupérer le substrat de départ (celui-ci n'étant pas consommé, contrairement aux méthodes de gravure mécanique/physique/chimique couramment utilisées).

De manière générale, les avantages de la présente invention résident dans le transfert d'une couche piézoélectrique ou pyroélectrique ou ferroélectrique (prélevée du substrat monocristallin massif) sur un substrat temporaire, dans la capacité à disposer d'une zone d'interface fragile de séparation supportant le budget thermique et les contraintes thermomécaniques associées, dans la capacité à disposer d'un second collage, définitif lui, de la couche piézoélectrique ou pyroélectrique ou ferroélectrique sur un substrat définitif, et enfin dans la possibilité de détacher la couche piézoélectrique ou pyroélectrique ou ferroélectrique du substrat temporaire sans la détacher du substrat définitif.

De manière générale, on peut réaliser une interface fragile lorsque deux composés mis en contact présentent une interdiffusion conduisant à la génération de contraintes et/ou de défauts structurels. Parmi les réactions connues pour générer des fragilités, on peut citer la siliciuration de métaux (W, Ti, Co, Ni, Mo, Ta, Ru...) qui se produit à haute température lorsque ces métaux sont mis en contact avec du silicium. Il se produit alors des composés (WSi₂, TiSi₂, CoSi₂, NiSi, MoSi₂, TaSi₂, Ru₂Si₃, ...) qui présentent un volume supérieur à celui du métal d'origine, entraînant l'apparition de fortes contraintes qui peuvent conduire à la délamination de l'interface comme décrit dans l'article de O. Thomas, Les siliciures de métaux de transition en microélectronique : propriétés mécaniques et contraintes induites au cours de la formation en phase solide, PlastOx 2007, 277-286 (2009) ou dans l'article de C.S. Petersson, J.E.E. Baglin, J.J. Dempsey, F.M. d'Heurle, S.J. La Placa, Silicides of ruthénium and osmium : thin film reactions, diffusion, nucleation and stability, Journal of Applied Physics 53, 4866 (1982).

Une interface fragile peut également se former lorsque l'une des couches mise en contact au niveau de l'interface de séparation comporte au moins du SiO₂ et/ou du nitrure de silicium (tel que du SiN et/ou du Si₃N₄), et l'autre comporte au moins un métal noble (platine Pt, or Au, argent Ag, rhodium Rh, osmium Os, palladium Pd, ruthénium Ru, iridium Ir) [G. Le Rhun, C. Dieppedale and S. Fanget, *Procédé de transfert de couche(s) de matériau depuis un premier substrat sur un deuxième substrat,* brevet n° FR 3082997]. L'application d'un recuit à une température supérieure à un certain seuil dépendant du couple de matériaux choisis durant l'étape 3 du procédé décrit précédemment provoque la migration du métal noble dans la couche d'oxyde ou de nitrure de silicium et la fragilisation de l'interface, qui pourra ultérieurement être ouverte à l'étape 7 telle que décrite précédemment par une assistance mécanique.

Après transfert de la couche mince piézoélectrique, à l'étape 2 du procédé décrit précédemment, le budget thermique restant modéré, les phénomènes d'interdiffusion ne sont pas encore activés. En fournissant à l'empilement, au cours de l'étape 3 du procédé décrit précédemment un budget thermique conséquent, le recuit de guérison de la couche piézoélectrique (typiquement compris entre 300 et 700°C, pour une durée de 1 à 10 h) conduit également à la formation d'une interface fragile en provoquant la diffusion de métal dans l'oxyde ou le nitrure de silicium. Cette interface maintient suffisamment d'énergie d'adhérence pour autoriser les étapes 4-6 du procédé décrit précédemment, mais sa fragilité permet de provoquer un détachage par assistance mécanique, telle une insertion de lame, durant l'étape 7 du procédé décrit précédemment.

Compte tenu des spécificités du procédé de transfert de couche par « Crystal Ion Slicing » (CIS) (combinaison d'implantation ionique, de collage et de fracturation qui peut être induite thermiquement, mécaniquement ou chimiquement), il est à noter que :
- le premier collage, à l'étape 2 du procédé décrit précédemment, doit présenter une énergie de collage suffisante pour assurer la tenue mécanique de l'assemblage substrat temporaire / substrat donneur malgré de fortes contraintes thermomécaniques durant les étapes de fracture du substrat donneur et de polissage mécano-chimique, et être capable de supporter des recuits à des températures élevées (supérieures à 400°C, potentiellement jusqu'à 600°C). Typiquement, l'énergie d'adhérence doit être de l'ordre de 1 - 1.5 mJ/m². Ce collage doit également pouvoir être défait relativement simplement par détachage mécanique (par exemple par insertion de lame). Enfin, le dépôt de ce matériau doit pouvoir être effectué à basse température (idéalement, à température ambiante) afin de ne pas provoquer un murissement prématuré des défauts d'implantation;
- le second collage, à l'étape 6, quant à lui, doit répondre aux contraintes suivantes: présenter une forte énergie d'adhérence, afin d'assurer la tenue de la couche reportée durant la suite du procédé de fabrication, notamment durant les étapes faisant intervenir un budget thermique élevé, ainsi que la fiabilité du composant à l'issue de la fabrication; résister à l'étape de détachement du premier collage temporaire. Il faut donc privilégier des couches de collage minérales (par exemple : SiO₂, SiOₓN_{y}) ou métalliques (par exemple : Cuivre, Or, ...) possédant une énergie supérieure à celle de l'interface de détachage (typiquement, supérieure à 2 - 3 mJ/cm²).

Idéalement, le matériau de collage possède un caractère planarisant afin de faciliter l'encapsulation de couches insérées avant le second report (telles que par exemple des électrodes inférieures) et doit pouvoir être planarisé avant collage. La contrainte sur la tenue en température de cette couche et fortement relâchée, et ne dépend plus que de la suite du procédé. Ceci permet par exemple d'intégrer éventuellement à la liste des candidats possibles des collages polymères, qui d'habitude ne supportent pas des budgets thermiques élevés (> 300°C).

Il est à noter que même si la problématique de résonateurs à ondes acoustiques de volume a été exposé précédemment, la présente invention peut tout à fait s'appliquer à tout type de composant nécessitant le report d'une couche monocristalline nécessitant une étape de recuit de guérison à température relativement élevée et l'intégration par ailleurs de matériaux ne supportant potentiellement pas ces recuits. Les applications possibles comportent tout autre type de composants à ondes élastiques (filtres SAW ou à ondes de Lamb), mais également potentiellement des applications utilisant les propriétés piézoélectriques et ferroélectriques du matériau, tels que par exemple des capteurs pyroélectriques.

Afin d'illustrer la diversité de composants pouvant avantageusement être fabriqués en utilisant le procédé de la présente invention, le Demandeur décrit ci-après quelques exemples d'application.

### Première variante de l'invention comprenant la réalisation d'un résonateur à ondes élastiques de volume dénommé BAW (Bulk Acoustic Wave) en niobate de lithium :

### Etape 1.1:

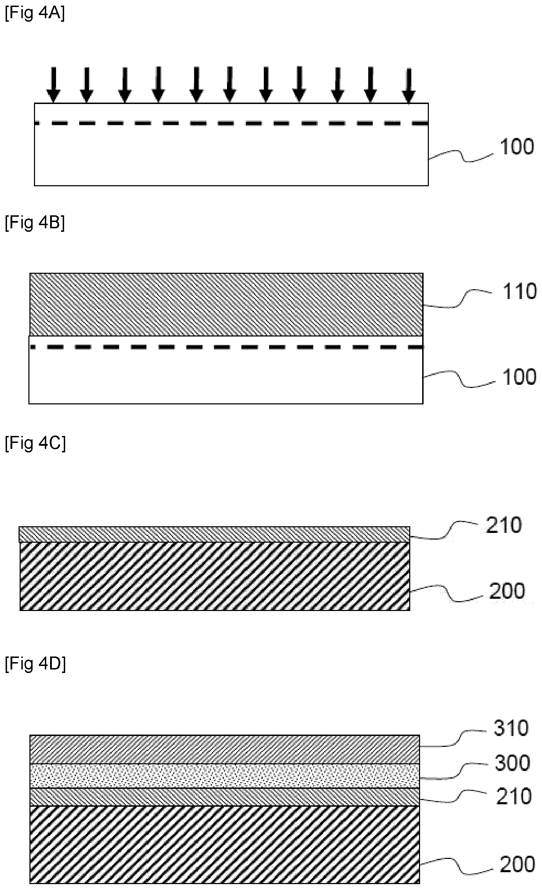

On procède à une opération d'implantation d'ions légers (He, H) dans un substrat donneur de niobate de lithium **100** comme illustré en figure 4A.

### Etape 1.2:

On procède au dépôt d'une couche de collage **110** sur le substrat donneur **100** qui peut être par exemple, une couche de SiO₂, déposée par pulvérisation réactive d'une cible de Si par un plasma Ar/O₂ comme illustré en figure 4B. On procède ensuite à une opération de polissage mécano-chimique (CMP) et/ou activation plasma.

### Etape 1.3:

En parallèle, on procède au dépôt d'une couche d'oxyde **210** sur un substrat receveur temporaire **200.** La couche d'oxyde peut être identique à celle réalisée sur le substrat donneur ou être un oxyde thermique, come illustré en figure 4C. De même, le substrat receveur temporaire **200** peut être de même nature (LiNbO₃) ou de nature différente (Si, verre, saphir) que celle du substrat donneur **100.**

### Etape 1.4:

On procède à la réalisation de la zone d'interface fragile de séparation à la surface de l'ensemble couche de collage **210** sur substrat receveur temporaire **200.** Pour cela on réalise le dépôt d'un métal noble **300** (ex : Pt, Pd, Au) et le dépôt d'une couche de collage (oxyde) **310** puis on procède à une opération de polissage mécano-chimique et/ou activation plasma, comme illustré en figure 4D. La rugosité de la couche de métal noble peut typiquement être comprise entre 0.5 et 5 nm. Eventuellement, une couche d'accroche (ex : Cr, Ti, TiN, Ta, TaN, Ta₂O₅, TiO₂, WN, WO₃) peut être insérée entre la couche de métal noble et la couche d'oxyde de collage afin de favoriser l'adhérence de celle-ci. Cette couche d'accroche peut également faire office de couche barrière à la diffusion d'éléments dans le substrat.

### Etape 1.5:

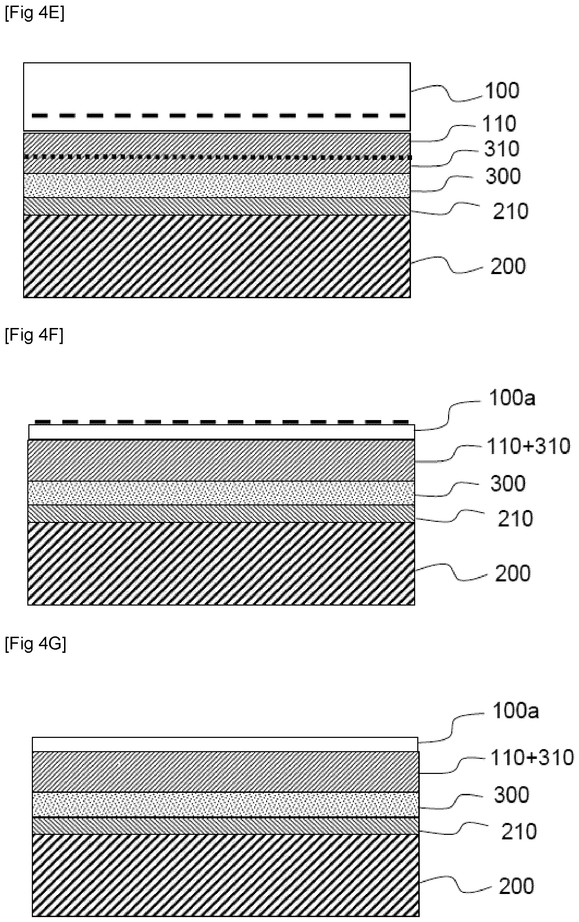

On procède au collage du substrat donneur **100** (plus couche de collage **110**) sur le substrat temporaire **200** (plus couche de collage **210,** plus zone d'interface fragile : **300** et **310**) comme illustré en figure 4E. Dans cet exemple, il s'agit d'un collage direct SiO₂/ SiO₂, réalisable par exemple par polissage des deux substrats, activation de surface, mise en contact, et recuit de consolidation, comme illustré en figure 4E. Afin de s'affranchir des effets de dilatation différentielle entre substrats donneur et temporaire, on utilise dans cet exemple un substrat temporaire de niobate de lithium (de la même orientation cristalline que le donneur).

### Etape 1.6 :

On procède au détachage de la couche reportée **100a** ainsi laissée à nu, dans cet exemple par procédé "Smart Cut" (technologie développée par le Demandeur) et à un recuit de fracturation, comme illustré en figure 4F.

### Etape 1.7 :

On procède à un recuit de guérison, puis polissage de la couche reportée **100a** et ajustement de son épaisseur, ou inversement, polissage de la couche reportée, ajustement de son épaisseur et recuit de guérison, comme illustré en figure 4G.

### Etape 1.8 :

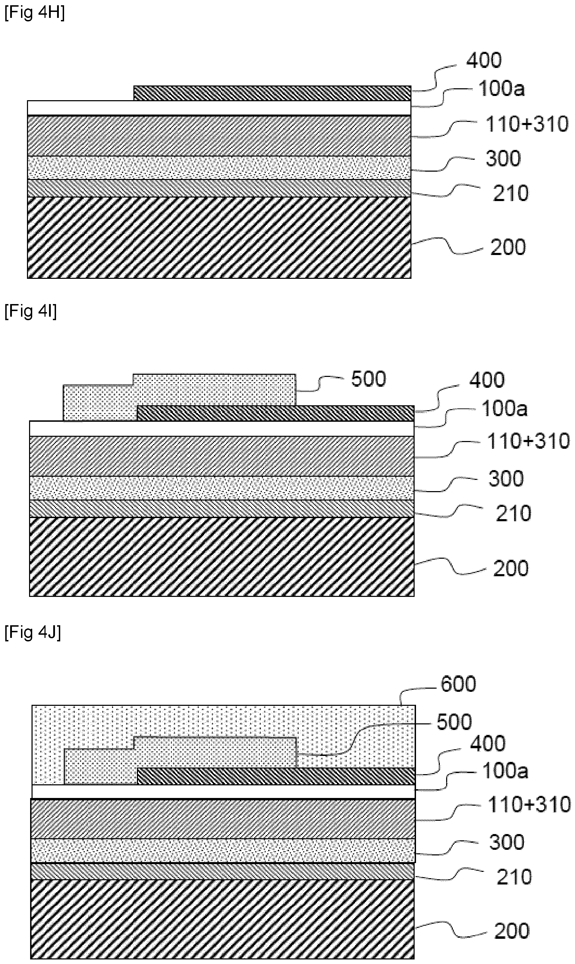

On procède au dépôt de l'électrode inférieure **400** (par exemple en Aluminium, par pulvérisation), puis à des opérations de photolithographie, gravure (par exemple, par voie chimique) de la couche métallique, et retrait de résine, comme illustré en figure 4H.

### Etape 1.9 :

On procède au dépôt d'une couche sacrifiée **500,** par exemple en silicium amorphe, photolithographie, gravure ionique réactive et retrait de résine, pour définir des caissons de libération, comme illustré en figure 4I.

### Etape 1.10 :

On procède au dépôt d'une couche de collage **600** (par exemple en SiO₂, par pulvérisation réactive d'une cible de silicium par un plasma Ar/O₂), et à une opération de polissage mécano-chimique (CMP) pour supprimer la topologie causée par la présence de l'électrode inférieure et du caisson de libération, comme illustré en figure 4J.

### Etape 1.11 :

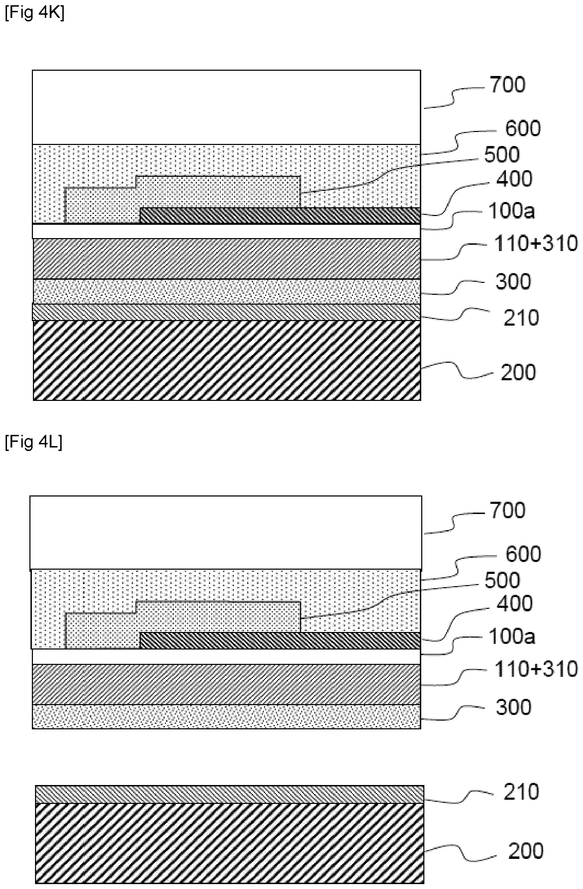

On procède à une seconde opération d'assemblage par collage du substrat temporaire **200** sur le substrat définitif **700,** comme illustré en figure 4K. On reprend le même procédé que pour le premier collage. Pour s'affranchir des effets de dilatation différentielle, on utilise avantageusement un substrat définitif en niobate de lithium, et de la même orientation cristalline que celle du substrat temporaire.

### Etape 1.12 :

On procède à l'opération de séparation des deux substrats au niveau de la zone d'interface fragile de séparation comprenant la couche **300,** comme illustré en figure 4L, de manière à procéder au décollement (détachage) pouvant être réalisé avantageusement par insertion de lame au niveau de l'interface fragile.

### Etape 1.13 :

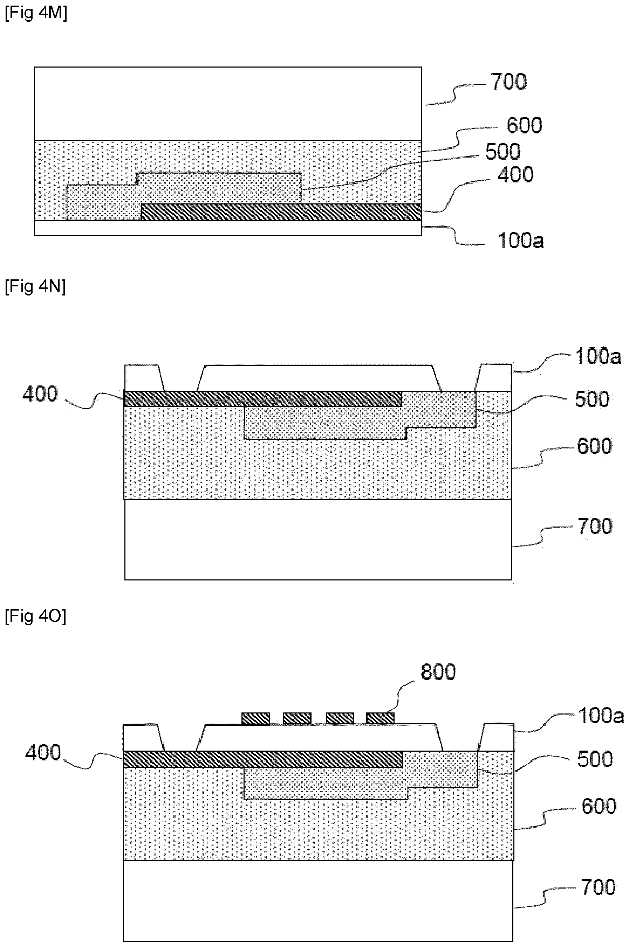

On procède au retrait de la couche de métal **300** comprise dans la zone d'interface fragile de séparation laissant à nu la couche d'intérêt **100a,** comme illustré en figure 4M. Il peut typiquement s'agir du retrait de métal Pt par gravure sèche et retrait de l'oxyde en HF.

La suite du procédé peut typiquement reprendre les mêmes étapes que présentées dans l'état de l'art.

### Etape 1.14:

On procède à la gravure d'ouvertures dans la couche d'intérêt **100a,** soit le film de niobate de lithium reporté, par exemple par photolithographie, gravure par faisceau d'ions (IBE) et retrait de résine, comme illustré en figure 4N.

### Etape 1.15:

On procède à la formation des électrodes supérieures **800** à la surface de la couche d'intérêt structurée préalablement **100a,** par exemple en aluminium, par dépôt par pulvérisation, photolithographie, gravure humide et retrait de résine, comme illustré en figure 4O.

### Etape 1.16:

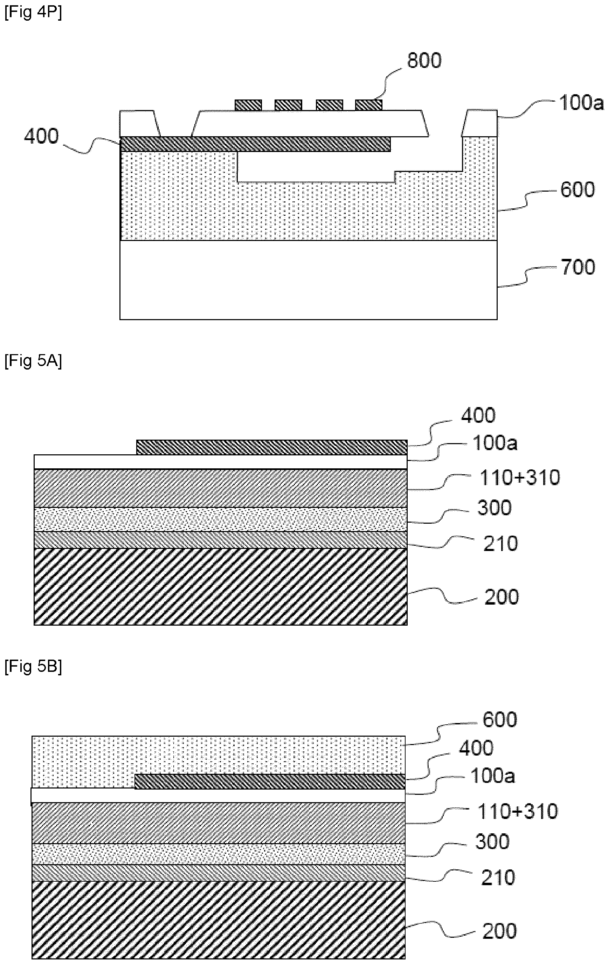

On procède à la libération des membranes contenant les résonateurs, par gravure des caissons de couche sacrifiée **500** (ici par XeF₂ gazeux pour dissoudre les caissons en silicium amorphe), comme illustré en figure 4P.

Il est à noter que cette première variante de réalisation propose une couche de détachage localisée directement en contact avec la couche reportée, sans que cela présuppose une localisation exacte de cette couche vis-à-vis de l'interface de collage. Il est par exemple possible de localiser cette couche sacrifiée en contact avec le substrat temporaire, voire même de l'insérer entre deux couches identiques à la couche de collage. Dans ces deux derniers cas, après le détachage du premier collage, il peut être prévu une étape de retrait de la couche résiduelle en contact avec la couche transférée si cette couche résiduelle n'est pas désirée dans l'empilement final.

### Seconde variante de l'invention dans laquelle le film mince piézoélectrique est reporté sur un substrat avec des cavités pré-définies

Selon cette variante, il n'y a pas de couche sacrificielle (aSi) comme présenté dans la première variante de procédé dans l'étape 1.9. L'isolation acoustique est réalisée via la formation de cavités pré-définies dans le substrat final. Un exemple de procédé utilisant cette variante est le suivant :

Première série d'étapes référencée étape 2.1: les mêmes étapes que celles décrites en étape 1.1 à étape 1.8 de la première variante de procédé peuvent être reproduites, conduisant à la structure illustrée en figure 5A et montrant l'empilement de couches : **200/210/300/310/110/100a,** avec une électrode **400,** la couche **100a** correspondant à la couche de matériau piézoélectrique.

### Etape 2.2 :

On procède au dépôt d'une couche de collage **600** (par exemple en SiO₂, par pulvérisation réactive d'une cible de silicium par un plasma Ar/O₂) puis à une opération de polissage mécano-chimique (CMP) pour supprimer la topologie causée par la présence de l'électrode inférieure et du caisson de libération, comme illustré en figure 5B.

### Etape 2.3 :

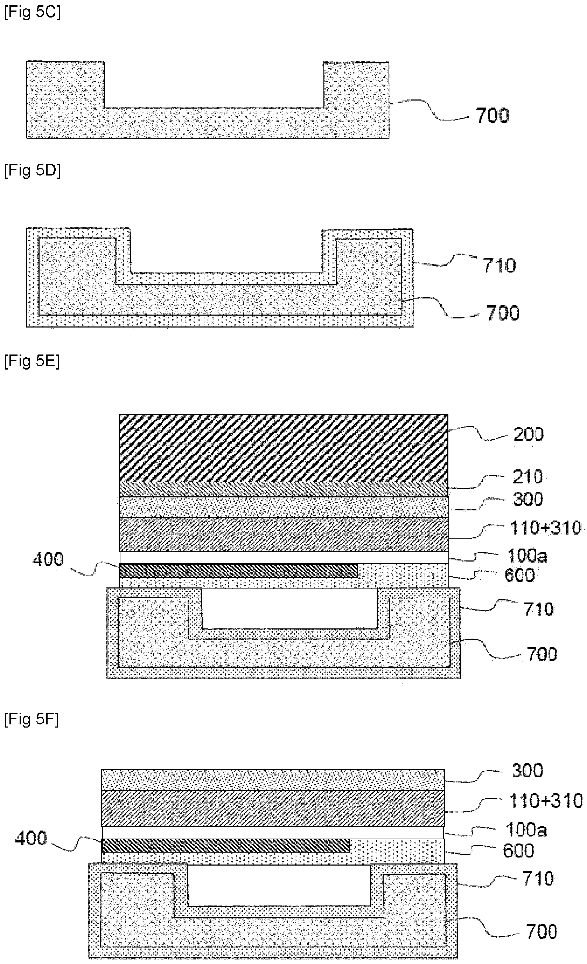

On procède à la réalisation de cavités pré-définies dans le substrat final **700** (Si, Verre, Saphir, LNO, LTO) par photolitographie, gravure physique et/ou chimique, puis retrait de résine (ou délaquage), comme illustré en figure 5C.

### Etape 2.4:

On procède à la réalisation du dépôt d'une couche d'oxyde de collage **710** (préférentiellement par voie chimique pour la conformité) ou oxydation thermique (cas présenté). L'oxyde peut présenter une rugosité RMS comprise entre 0.1 et 0.5 Å et est compatible collage direct, comme illustré en figure 5D.

### Etape 2.5 :

On vient ensuite assembler le substrat temporaire **200** et le substrat final **700** via toutes les couches intermédiaires préalablement élaborées, puis on procède à un recuit de consolidation, comme illustré en figure 5E.

### Etape 2.6 :

On procède au détachage du substrat temporaire **200** (avantageusement par insertion d'une lame) au niveau de la zone d'interface fragile de séparation comme illustré en figure 5F, puis on procède à la gravure des matériaux constituant l'interface fragile.

### Dernière série d'étapes référencée : Etape 2.7:

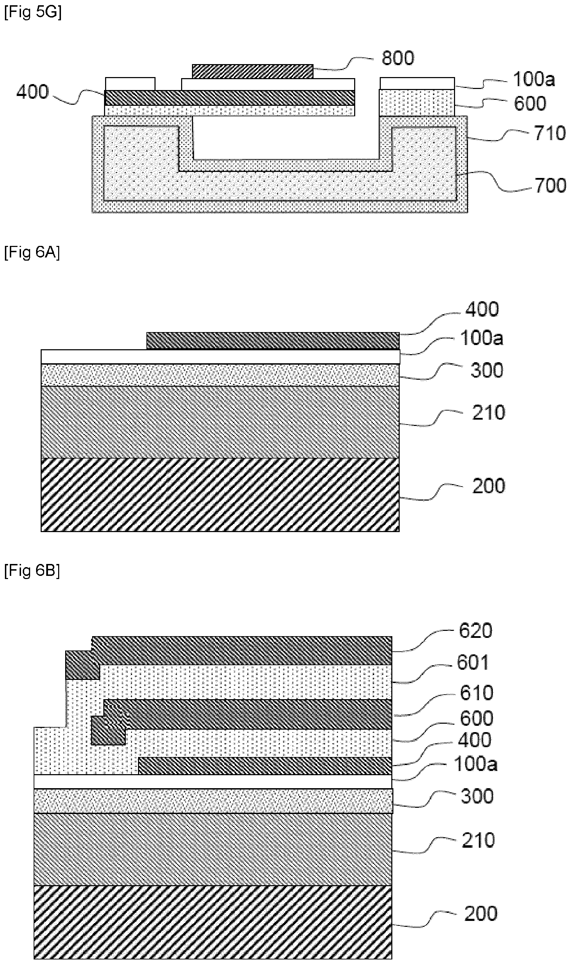

On termine le procédé de réalisation selon les mêmes étapes que celles décrites dans les étapes de la première variante conduisant à la structure illustrée en figure 5G mettant en évidence la couche d'intérêt structurée **100a** comprise entre les électrodes **400** et **800.**

### Troisième variante de l'invention comprenant le report d'un film mince monocristallin sur Silicium :

Une des problématiques mentionnées dans l'état de l'art consiste dans le fait d'être capable de reporter une couche mince piézoélectrique monocristalline sur silicium. Ceci est lié en partie à la nécessité d'appliquer des traitements thermiques à haute température, ce qui, combiné aux fortes différences de coefficient de dilatation thermique entre ces matériaux et le silicium, conduit souvent à la casse des échantillons. Le Demandeur propose ainsi l'utilisation de l'invention pour reporter plus facilement la couche piézoélectrique sur silicium.

Le procédé de réalisation est alors en tout point identique aux procédés précédents. On procède à un premier report de la couche mince piézoélectrique sur un substrat temporaire identique au substrat donneur (on parle alors de report en homostructure). Ceci permet de limiter les effets de contraintes thermoélastiques durant les étapes de collage, de fracture et de recuits à haute température. Lors du second report, on bénéficie alors des relativement faibles températures de recuit de collage nécessaires aux étapes 1.10) ou 2.5) (typiquement de l'ordre de 150 à 200°C en fonction des matériaux en présence) pour limiter les contraintes thermomécaniques issues du différentiel de dilatation thermique entre les substrats temporaire et final. Les risques de casse des plaques collées ensemble sont donc quasiment annulés, ce qui permet d'envisager l'utilisation d'un substrat de silicium comme substrat définitif.

Il est à noter que si la couche transférée est suffisamment fine par rapport au substrat temporaire (inférieure au micron, pour un substrat de l'ordre de 500 µm), elle ne pourra pas générer de contraintes thermoélastiques durant les étapes de recuits : au contraire, elle subira la dilatation du substrat de manière élastique. Dans ce cas, si le collage est suffisamment fort pour que les risques de délaminations soient réduits on peut envisager un report directement sur un substrat définitif différent du substrat donneur.

### Quatrième variante de l'invention comprenant la réalisation d'un composant à ondes de plaques.

Les modes de réalisation précédents peuvent être utilisés pour d'autres types de résonateurs que des résonateurs BAW. Ils peuvent par exemple être utilisés pour réaliser des résonateurs à ondes élastiques de plaques (aussi appelés à ondes de Lamb, ou à modes de contour, ...). Une des variantes de ces composants est appelée VFE, pour *Vertical Field Excitation* : les ondes de plaque sont excitées dans une membrane piézoélectrique par l'application d'un champ électrique orienté selon l'épaisseur de la plaque, ce qui est obtenu par la disposition d'une électrode flottante sur une des faces de la membrane (par exemple inférieure) et d'électrodes en forme de peignes interdigités sur la face opposée. Le procédé de réalisation de ces composants est donc très analogue à celui d'un résonateur à ondes de volume : seules diffèrent les géométries des motifs d'électrodes et de couches sacrifiées.

Une autre variante de ces composants à ondes de plaques est appelée LFE, pour *Latéral Field Excitation* : les ondes de plaques sont excitées dans une membrane piézoélectrique cette fois-ci par l'application d'un champ électrique horizontal, ce qui est obtenu en ne disposant des électrodes, toujours en forme de peignes interdigités, que sur l'une des faces de la plaque. Le procédé de réalisation est alors en tout point similaire, hormis la suppression des étapes nécessaires à la réalisation d'électrodes inférieures ou supérieures.

### Cinquième variante de l'invention comprenant la réalisation d'un résonateur à ondes acoustiques de volume sur miroir de Bragg ou à ondes guidées :

Des variantes de résonateurs à ondes acoustique de volume ou à ondes acoustiques de plaque utilisent un miroir de Bragg en remplacement d'une cavité d'air afin de confiner les ondes élastiques dans la couche piézoélectrique. On parle alors respectivement de résonateur SMR (pour *Solidly Mounted Resonator*) ou de résonateur à ondes guidées. Ces miroirs sont réalisés en empilant des couches présentant alternativement des impédances acoustiques faibles et élevées (par exemple, SiO₂/W, ou SiO₂/Mo, ou SiO₂/AlN ou SiOC/SiN, ...), et d'épaisseurs sensiblement égales à un quart de longueur d'onde, quoique des variantes existent qui dérogent à cette règle pour optimiser les caractéristiques acoustiques de ces miroirs.

L'intégration de tels miroirs dans des résonateurs en niobate de lithium, par exemple, est délicate car les dépôts des couches de ces structures sont généralement réalisés à haute température afin de fournir des matériaux relativement denses, peu poreux, et donc présentant des atténuations acoustiques raisonnables. Ces températures de dépôt élevées (typiquement de l'ordre de 400 à 500°C), couplées à la durée des dépôts nécessaires pour réaliser les empilements complets, et les problématiques de contraintes dans ces couches, rendent la réalisation selon les procédés de l'état de l'art de ces miroirs sur le substrat donneur complexe. Par contre, l'utilisation de l'invention présentée ici, permet d'envisager la réalisation de miroirs sur la couche reportée guérie, qui peut supporter des températures entre 400 et 500°C (proches des températures de recuit de guérison).

Un exemple de procédé de réalisation incluant de tels miroirs, et inspiré de la première variante de procédé de réalisation est décrit ci-après :

### Une première série d'étapes référencée Etape 5.1 :

Des étapes similaires à celles des étapes 1.1 à 1.7 de la première variante sont réalisées et conduisent à la structure illustrée en figure 6A, mettant en évidence la couche d'intérêt **100a,** à la surface de la zone d'interface fragile de séparation comprenant la couche **300** et réalisée à la surface du substrat temporaire **200** recouvert d'une couche **210,** la couche d'intérêt **100a** étant recouverte d'une électrode **400.**

### Etape 5.2:

On procède au dépôt d'un empilement de couches : en SiO₂ référencée **600**/ en W référencée **610/** en SiO₂ référencée **601**/en W référence **620,** par exemple par PECVD (*Plasma Enhanced Chemical Vapor Deposition*) pour le SiO₂ et par CVD (*Chemical Vapor Deposition*) pour le W. On réalise des opérations de photolithographie, et gravure ionique réactive du tricouche W / SiO₂ / W puis on procède au retrait de la résine. Ceci permet de délimiter les miroirs sous les résonateurs, comme illustré en figure 6B.

### Etape 5.3 :

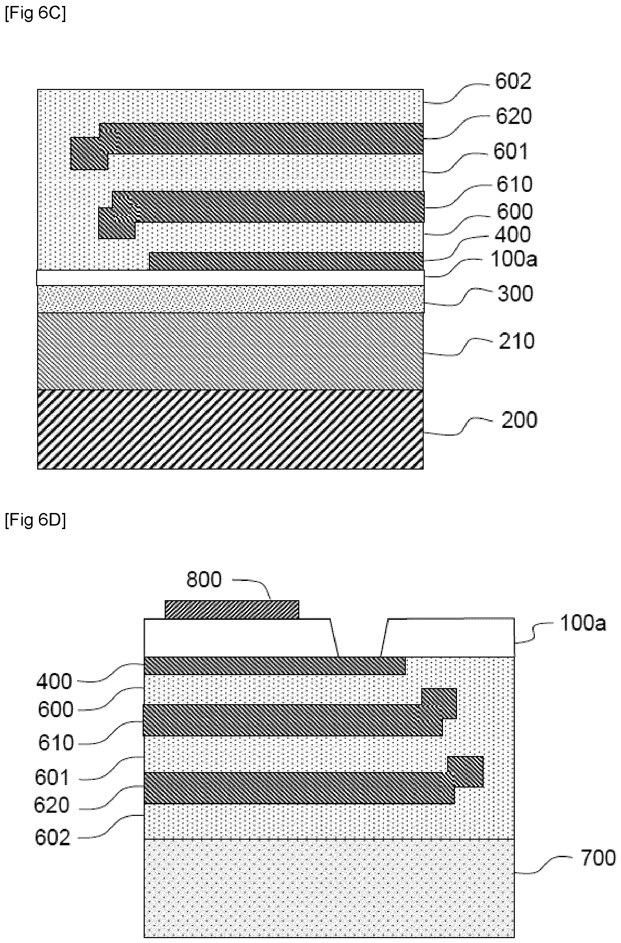

On procède au dépôt d'une couche **602** de SiO₂, toujours par PECVD. On réalise une opération de planarisation par polissage mécano-chimique, éventuellement assistée d'une pré-gravure de la couche de SiO₂ localisée sur les empilements W/SiO₂/W formés à l'étape précédente, comme illustré en figure 6C.

### Etape 5.4 :

On peut ensuite reprendre le cours du procédé de réalisation selon la première variante de procédé de fabrication pour venir reporter la couche piézoélectrique avec son miroir de Bragg sur un substrat final **700,** comme illustré en figure 6D.

### Sixième variante de l'invention comprenant un capteur pyroélectrique

L'invention n'est pas uniquement applicable au cas de résonateurs piézoélectriques et peut être généralisée à d'autres types de composants. Par ailleurs, elle n'est pas limitée à l'utilisation de matériau piézoélectrique tel que le niobate de lithium. A titre d'exemple, le Demandeur propose d'appliquer l'invention au cas de capteurs pyroélectriques à base de tantalate de lithium. Le principe consiste dans ce cas à réaliser des membranes de tantalate de lithium suspendues afin de les isoler thermiquement de leur substrat, et métallisées sur leurs deux faces afin de former des capacités métal / isolant / métal. Le principe de ces capteurs consiste à mesurer la variation de capacité observée lorsqu'un rayonnement thermique vient échauffer la capacité suspendue.

Les exemples précédents ont montré l'utilisation de caissons de libération pour former des membranes suspendues. Il est tout à fait possible dans le cas présent, si l'on est capable de reporter la couche de tantalate de lithium sur silicium grâce à l'invention, de venir graver le silicium en face arrière.

### Etape 6.1 :

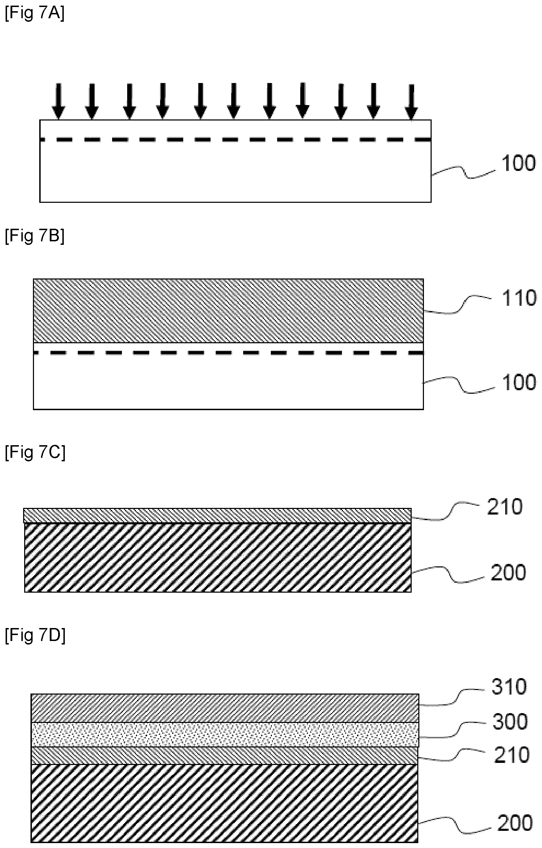

On procède à Implantation d'ions légers dans un substrat **100** de tantalate de lithium, comme illustré en figure 7A.

### Etape 6.2:

On procède au dépôt d'une couche de collage **110** sur le substrat donneur. Dans cet exemple, il est proposé d'utiliser des couches de SiO₂, déposées par pulvérisation réactive d'une cible de Si par un plasma Ar/O₂. On procède à une opération de polissage mécano-chimique (CMP) et/ou activation plasma, comme illustré en figure 7B.

### Etape 6.3:

On procède au dépôt d'une couche d'oxyde **210** sur le substrat receveur temporaire **200** comme illustré en figure 7C. La couche d'oxyde peut être identique à celle du substrat donneur ou être un oxyde thermique. De même, le substrat receveur temporaire **200** peut être de même nature (LiTaO₃) ou de nature différente (Si, verre, saphir) que le substrat donneur.

### Etape 6.4 :

On procède à la réalisation de la zone d'interface fragile de séparation par dépôt d'un métal noble (ex : Pt, Pd, Au) **300** et dépôt d'une couche de collage (oxyde) **310.** Puis on procède à une opération de polissage mécano-chimique et/ou activation plasma, comme illustré en figure 7D. Eventuellement, une couche d'accroche (ex : Cr, Ti, TiN, Ta, TaN, Ta₂O₅, TiO₂, WN, WO₃) peut être insérée entre la couche de métal noble et la couche d'oxyde de collage afin de favoriser l'adhérence de celle-ci.

### Etape 6.5:

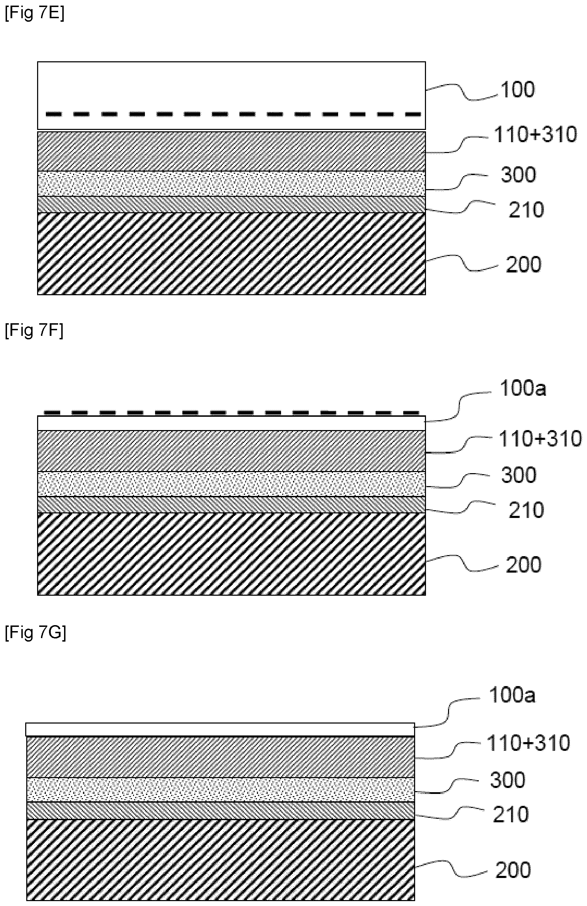

On procède au collage du substrat donneur **100** sur le substrat temporaire **200** comme illustré en figure 7E. Dans cet exemple, il s'agit d'un collage direct SiO₂/ SiO₂, réalisable par exemple par polissage des deux substrats, activation de surface, mise en contact, et recuit de consolidation. Afin de s'affranchir des effets de dilatation différentielle entre substrats donneur et temporaire, on utilise dans cet exemple un substrat temporaire de niobate de lithium (de la même orientation cristalline que celle du substrat donneur).

### Etape 6.6:

On procède au détachage de la couche reportée, dans cet exemple par procédé de type procédé "Smart Cut" : recuit de fracturation, comme illustré en figure 7F, permettant de définir la couche mince d'intérêt dans le matériau **100.**

### Etape 6.7:

On procède à un recuit de guérison, puis au polissage de la couche reportée **100** et ajustement de son épaisseur, ou inversement, polissage de la couche reportée, ajustement de son épaisseur et recuit de guérison, comme illustré en figure 7G.

### Etape 6.8:

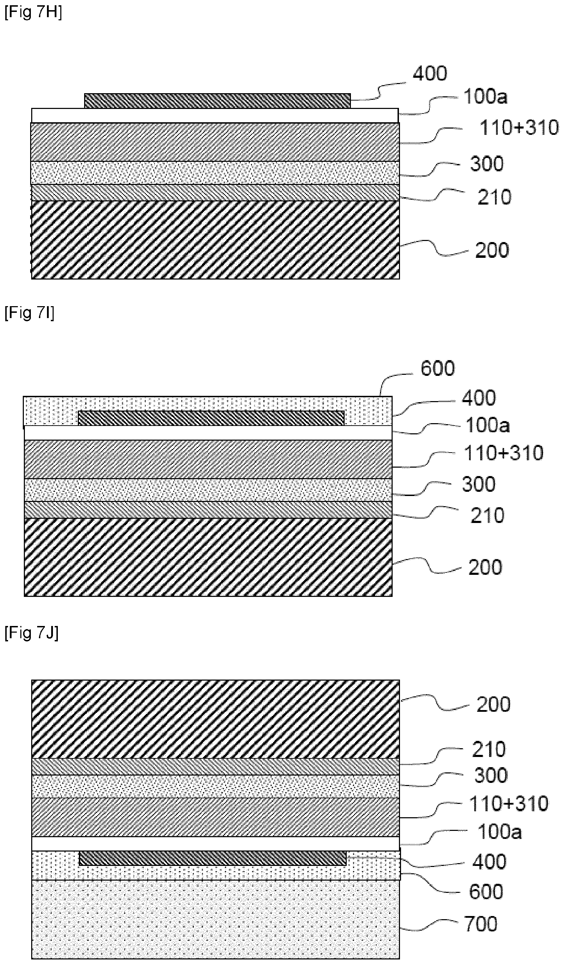

On procède au dépôt de l'électrode inférieure **400** (par exemple en Aluminium, par pulvérisation), photolithographie et gravure (par exemple, par chimique) de la couche métallique, et retrait de résine, comme illustré en figure 7H.

### Etape 6.9:

On procède au dépôt d'une couche de collage **600** (par exemple en SiO₂, par pulvérisation réactive d'une cible de silicium par un plasma Ar/O₂). On réalise une opération de polissage mécano-chimique (CMP) pour supprimer la topologie causée par la présence de l'électrode inférieure et du caisson de libération, comme illustré en figure 7I.

### Etape 6.10:

On procède à une seconde opération de collage du substrat temporaire **200** sur le substrat définitif **700,** comme illustré en figure 7J. Dans cet exemple, on reprend dans cet exemple le même procédé que pour le premier collage : il s'agit d'un collage direct SiO₂/ SiO₂, réalisable par exemple par polissage des deux substrats, activation de surface, mise en contact, et recuit de consolidation. Comme pour l'étape 6.3, afin de s'affranchir des effets de dilatation différentielle entre substrats donneur et temporaire, on utilise dans cet exemple un substrat temporaire de niobate de lithium (de la même orientation cristalline que celle du substrat temporaire).

### Etape 6.11:

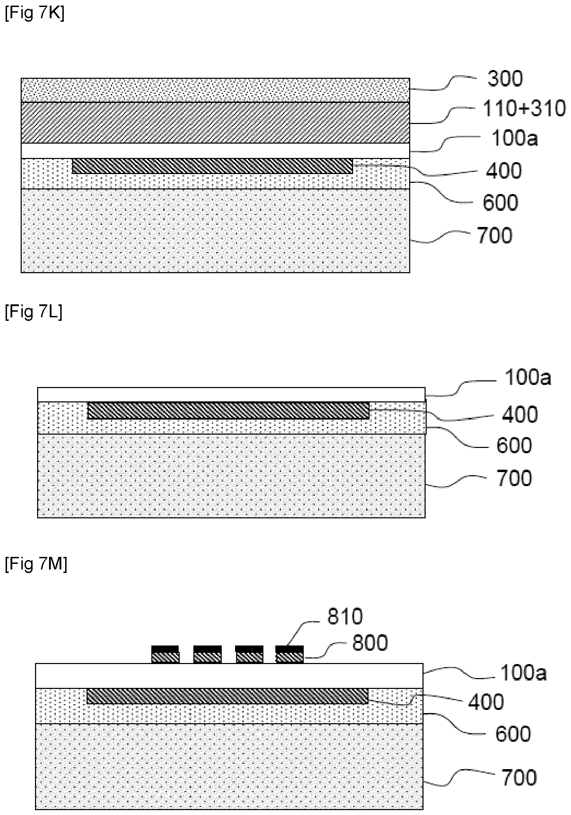

On procède à une opération de séparation au niveau de l'interface fragile comme illustré en figure 7K puis au retrait des couches de l'interface fragile **300** et **310+110** par gravure sèche et/ou gravure humide comme illustré en figure 7L.

### Etape 6.12:

On procède au dépôt d'une électrode supérieure **800** et d'une couche d'absorption du rayonnement infrarouge **810** et à la définition des électrodes supérieures et de cette couche pour former des capacités, comme illustré en figure 7M.

### Etape 6.13:

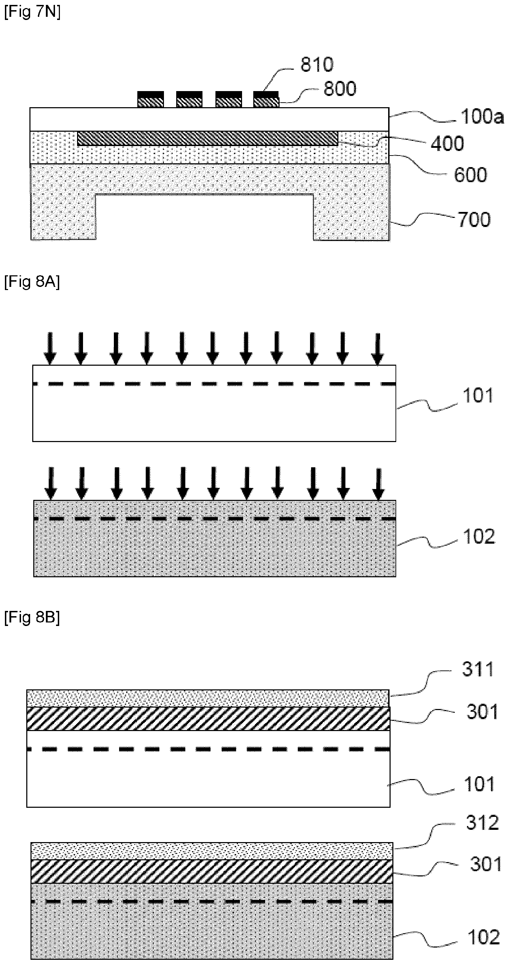

On procède à la gravure du substrat face arrière par gravure profonde du silicium (ex : DRIE), comme illustré en figure 7N.

### Septième variante de l'invention comprenant la réalisation d'un résonateur composite ou filtre à couplage longitudinal.

Certaines variantes de résonateurs à ondes de volume appelées « résonateurs composites » ont été proposées dans la littérature, par exemple pour fournir des résonateurs agiles en fréquence. Dans ce cas, le résonateur est composé de deux couches piézoélectriques et de jeux d'électrodes respectifs, une partie de l'empilement étant connectée au circuit de filtre et l'autre à un circuit de pilotage en fréquence.

Une structure similaire peut être constituée par un jeu de résonateurs à ondes de volume empilés, et couplés mécaniquement par une ou plusieurs couches, de sorte à générer une fonction de filtre. Dans ce cas, chaque couche piézoélectrique constitue un résonateur, et l'un des résonateurs fait office d'entrée et l'autre de sortie du filtre. On parle alors de *Coupled Resonator Filter* (CRF) ou de *Stacked Crystal Filter* (SCF). Par rapport aux résonateurs composites, seules diffèrent finalement les épaisseurs des couches et les géométries des électrodes, mais un même procédé de réalisation peut être envisagé.

Un procédé de réalisation de résonateurs composite selon l'état de l'art et faisant intervenir des reports de couches est par exemple décrit dans la demande de brevet FR3076126. Elle consiste à réaliser successivement deux étapes de report de couche, incluant chacune un recuit de guérison. Ainsi, lors du recuit de guérison de la seconde couche reportée, l'empilement constitué de la première couche et des électrodes associées subit à nouveau un recuit relativement long à température élevée. Ceci peut s'avérer particulièrement dramatique pour l'électrode localisée le plus profondément. Il est donc avantageux d'utiliser l'invention proposée ici pour chacun des reports de couche.

Un procédé de réalisation, tirant à la fois parti de la présente invention et de celle du dossier FR3076126, peut donc prendre la forme suivante :

### Etape 7.1:

On réalise une opération d'implantation d'ions légers dans deux substrats de niobate de lithium **101** et **102** comme illustré en figure 8A.

### Etape 7.2:

On réalise sur le premier substrat donneur **101** et sur le second substrat donneur **102,** une zone d'interface fragile de séparation, on réalise le dépôt et la planarisation d'une couche de collage en SiO₂, ces zones d'interface fragile de séparation respectivement **301/311** et **302/312** (permettront le détachage de substrats temporaires), comme illustré en figure 8B.

### Etape 7.3:

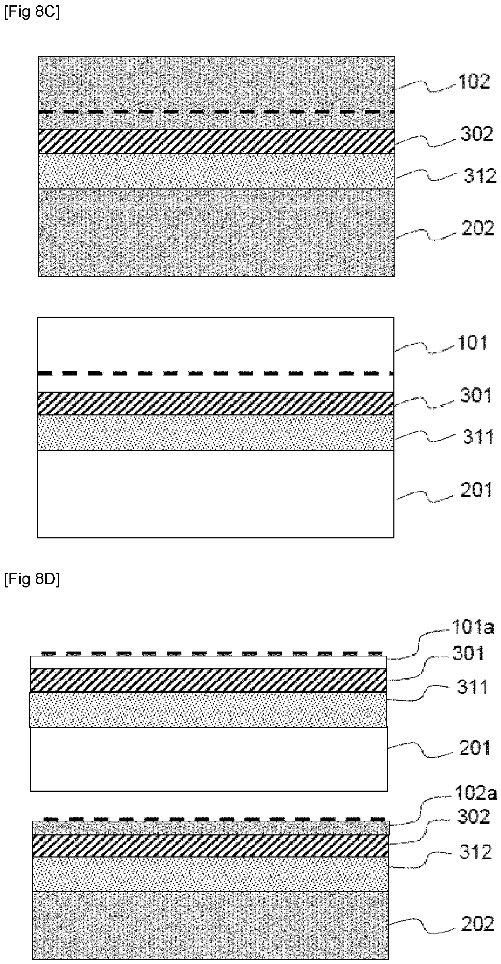

On procède à l'assemblage par collage des substrats donneurs **101** et **102** sur les substrats temporaires **201** et **202** comme illustré en figure 8C.

### Etape 7.4:

On procède à la fracture et au détachage des couches de niobate de lithium afin de réaliser les couches **101a** et **102a** comme illustré en figure 8D.

### Etape 7.5:

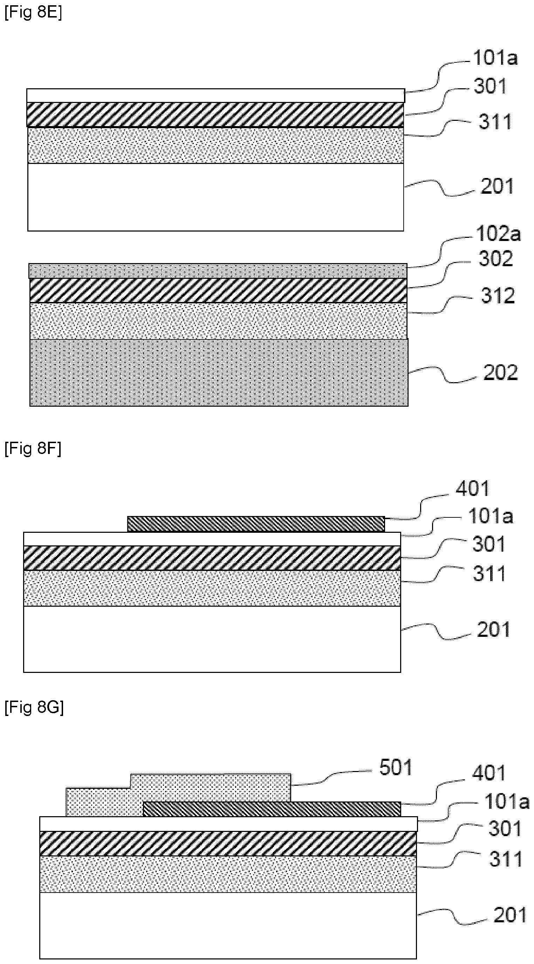

On procède à des opérations de recuits de guérison, de polissage et d'ajustement des épaisseurs des couches de niobate de lithium **101a** et **102a,** comme illustré en figure 8E.

### Etape 7.6 :

On procède au dépôt et à la structuration d'une électrode inférieure **401** (par exemple en Al déposé par pulvérisation à une température de 400°C) à la surface de la couche piézoélectrique inférieure **101a** comme illustré en figure 8F.

### Etape 7.7:

On procède au dépôt d'une couche de silicium amorphe **501,** à des opérations de photolithographie, gravure et retrait de résine de manière à former un caisson de couche sacrifiée comme illustré en figure 8G.

### Etape 7.8:

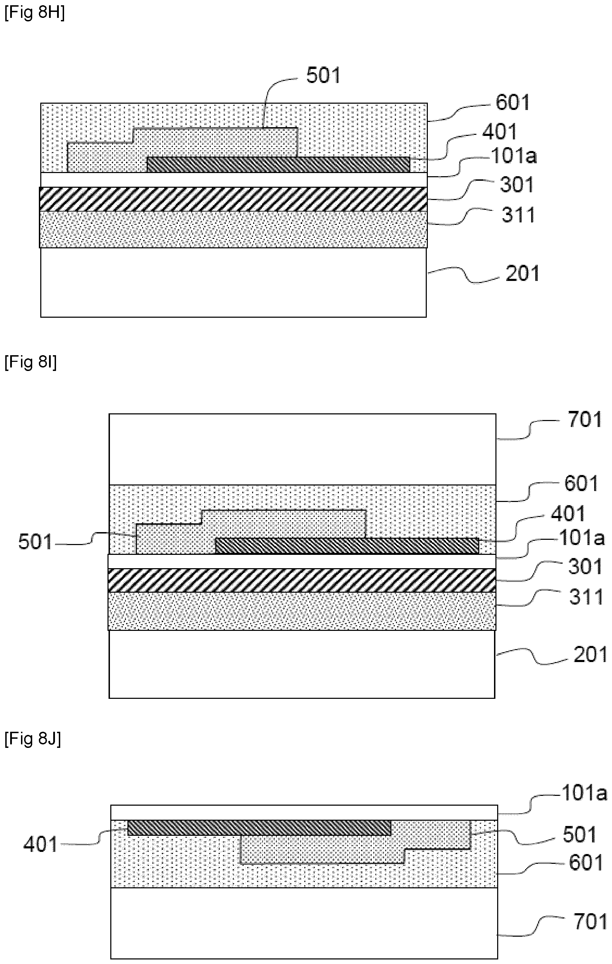

On procède au dépôt de la couche de collage définitif **601,** pouvant être de l'oxyde de silicium, comme illustré en figure 8H.

### Etape 7.9:

On procède au collage du premier substrat temporaire **201** sur le substrat définitif **701,** dans le cas présent en silicium oxydé thermiquement. Il peut être procéder à un collage direct SiO₂/SiO₂ après activation de la surface, comme illustré en figure 8I.

### Etape 7.10:

On procède au détachage du premier collage temporaire par insertion de lame comme illustré en figure 8J, pour laisser à nu la surface la couche d'intérêt **101a.**

### Etape 7.11:

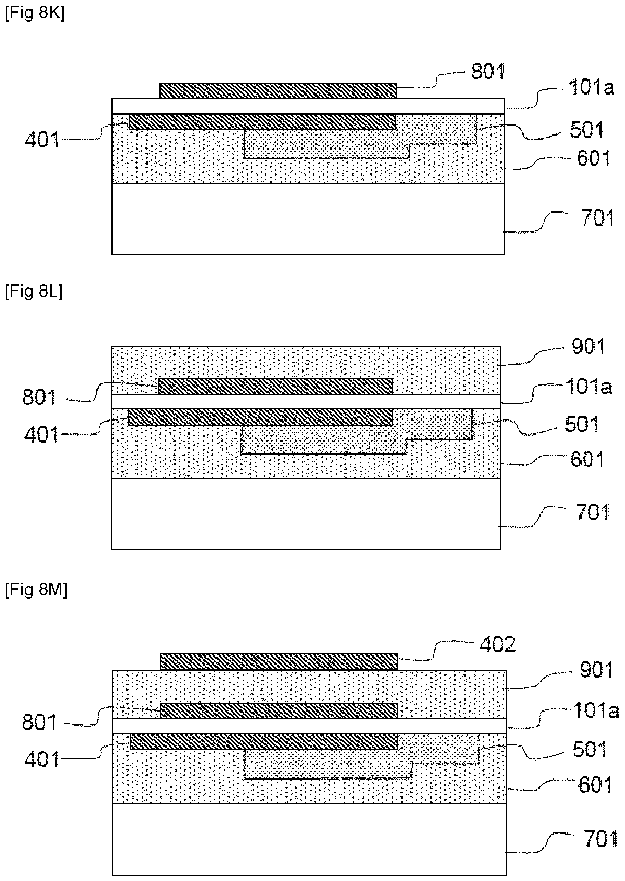

On procède au dépôt de métal (par exemple en Al déposé par pulvérisation à une température de 400°C) et à la structuration de l'électrode supérieure **801** de la première couche piézoélectrique **101a,** comme illustré en figure 8K.

### Etape 7.12:

On procède au dépôt d'une couche d'isolation ou de couplage **901** entre résonateur (en fonction de l'application visée), en SiO₂, comme illustré en figure 8L.

### Etape 7.13:

On procède au dépôt de métal (par exemple, toujours de l'Al) et à la structuration d'une électrode inférieure **402** de la couche piézoélectrique supérieure (qui sera reportée) comme illustré en figure 8M.

### Etape 7.14:

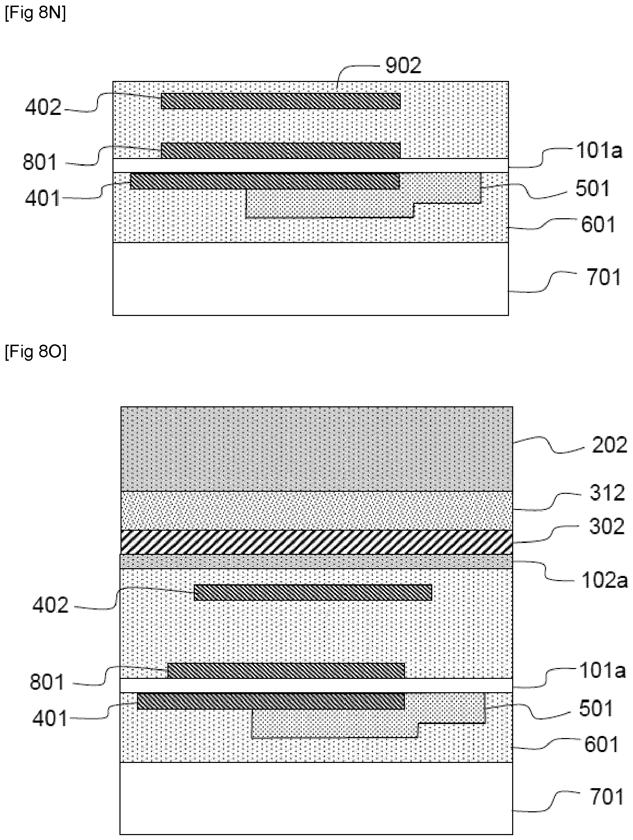

On procède au dépôt d'une couche **902** de SiO₂ et à la planarisation de la marche formée par les deux électrodes. On ne vient laisser qu'une très faible épaisseur de SiO₂ par-dessus l'électrode (de l'ordre de 10 à 20 nm), comme illustré en figure 8N.

### Etape 7.15:

On procède au dépôt d'une fine couche **302** de SiO₂ (environ 10 à 20 nm) sur le second substrat temporaire **202,** à la réalisation d'une zone d'interface fragile de séparation (comportant la couche de métal noble **312**), et au collage direct, puis recuit de consolidation du collage, comme illustré en figure 8O.

### Etape 7.16 :

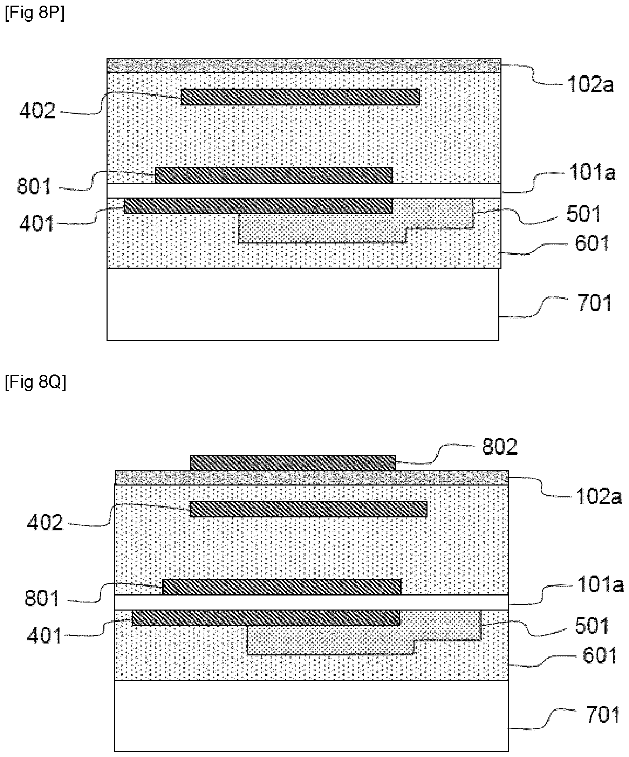

On procède à une opération de détachage du second substrat temporaire **202** par insertion de lame comme illustré en figure 8P, laissant à nu la seconde couche d'intérêt **102a.**

### Etape 7.17:

On procède au dépôt et à une opération de définition du quatrième niveau d'électrodes **802** pouvant être réalisé en Al, comme illustré en figure 8Q.

### Etape 7.18:

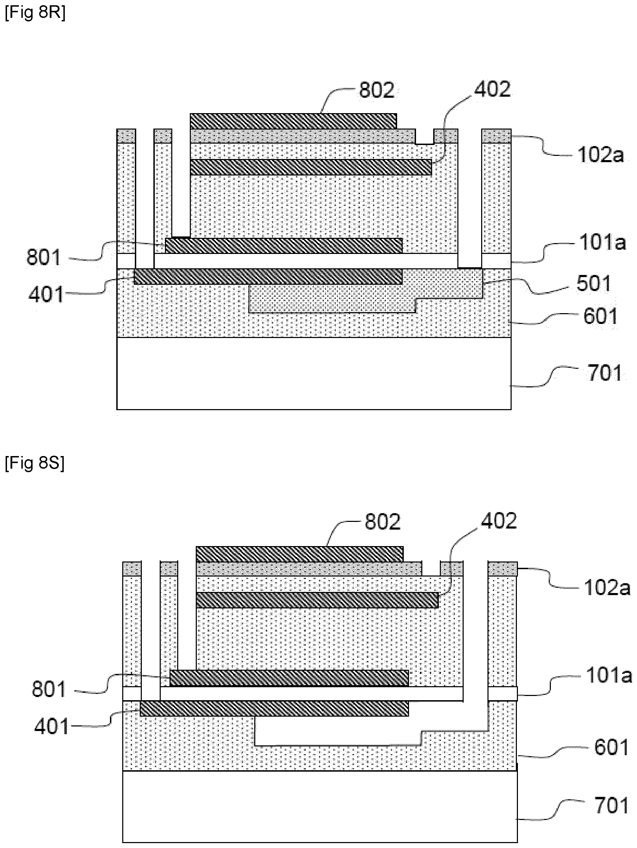

On procède à des opérations de gravures successives des différentes couches pour former des ouvertures permettant de reprendre des contacts électriques sur les différents niveaux d'électrodes, et de réaliser des ouvertures de libération débouchant dans les caissons de silicium amorphe **501** comme illustré en figure 8R.

### Etape 7.19:

On réalise la libération des résonateurs par gravure des caissons de silicium amorphe dans du XeF₂ gazeux, comme illustré en figure 8S, mettant en évidence les deux résonateurs avec leur couche d'intérêt **101a** et **102a** respectivement comprises entre les électrodes **401** et **801** et **402** et **802.**

La présente invention peut également être appliquée dans le cadre d'un couche plus épaisse de matériau piézoélectrique ou pyroélectrique ou ferroélectrique ou dans le cadre d'au moins deux couches de tels matériaux avec néanmoins des natures de matériaux différents. Dans ce cadre il est avantageusement prévu une étape de croissance intermédiaire, juste postérieure à l'obtention de la fine couche de matériau d'intérêt après opération de fracturation.

Dans ce cadre, le Demandeur décrit ci-après une huitième variante de l'invention, concernant l'un des modes de réalisation précédemment décrits et intégrant une étape de recroissance de film piézoélectrique.

Les modes de réalisation précédemment cités utilisent des films minces piézoélectriques monocristallins obtenus par la technologie selon le procédé « Smart Cut » (ou « Crystal Ion Slicing ») dont l'épaisseur est inférieure à 1 µm. L'épaisseur du film piézoélectrique est principalement dictée par l'énergie d'implantation. Par exemple, pour une énergie d'implantation de 220 keV (160 keV), l'épaisseur obtenue pour le LiNbO₃ (LiTaO₃) est de 600 - 750 nm (700 - 900 nm).

Néanmoins, les applications précédemment citées (capteurs pyroélectriques, résonateurs à ondes acoustiques de volume, résonateurs à ondes acoustiques de surface, résonateurs à ondes de plaque, récupération d'énergie, modulateurs électro-optiques, etc.) peuvent nécessiter l'utilisation de films minces monocristallins présentant des épaisseurs de film comprises entre 1 et 10 µm. Il n'existe à l'heure actuelle de techniques industrielles permettant l'obtention de films minces monocristallins présentant des épaisseurs comprises entre 1 et 10 µm et intégrant des couches enterrées fonctionnelles, électrodes patternées et/ou couche sacrificielle.

Ce mode de réalisation repose sur l'insertion d'une étape de dépôt de matériau de même nature ou similaire (en termes de nature chimique, structure cristalline et coefficient de dilatation) que la couche de matériau transférée par Smart Cut^{™} entre les étapes 1.7 (Recuit de guérison, puis polissage de la couche reportée et ajustement de son épaisseur, ou inversement, polissage de la couche reportée, ajustement de son épaisseur et recuit de guérison) et 1.8 (Dépôt de l'électrode inférieure (par exemple en Aluminium, par pulvérisation), photolithographie et gravure (par exemple, par voie chimique) de la couche métallique, et retrait de résine) de la première variante de l'invention. On se trouve alors dans le cas d'une croissance de type homoépitaxiale où la couche transférée par procédé « Smart Cut " (< 1µm) fera office de germe à la couche obtenue par dépôt (épaisseur comprise entre 0.01 et 5 µm). La couche déposée peut adopter alors la même structure que la couche transférée par procédé de type "Smart Cut". La recroissance d'une couche déposée permet ainsi d'obtenir une couche de matériau dont l'épaisseur peut être comprise entre 0.5 et 5 µm.

Enfin, il est à noter que la présente invention n'est pas limitée au cas des matériaux piézoélectriques de niobates alcalins et peut être généralisé à d'autres familles de matériaux comme les nitrures AlN, GaN, AsGa, Ge, etc.

### Exemple de procédé selon cette huitième variante :

Les premières étapes sont similaires par exemple aux étapes 1.1 juqu'à 1.7 décrites précédemment.

### Etape 8.1 :

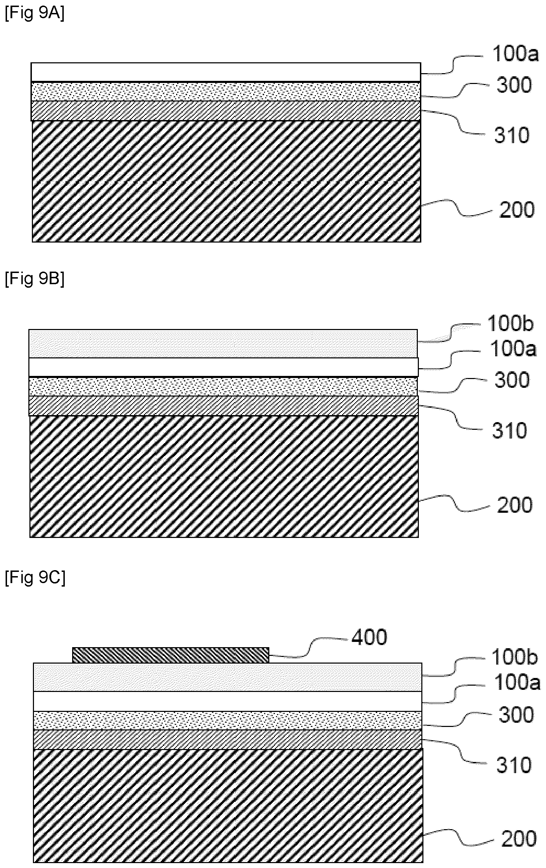

On procède à des opérations de recuit de guérison, puis polissage d'une couche de niobate de lithium « LNO » reportée et ajustement de son épaisseur, ou inversement, polissage de la couche reportée, ajustement de son épaisseur et recuit de guérison, comme illustré en figure 9A montrant un substrat temporaire **200,** une couche d'interface fragile de séparation **300** et une couche d'oxyde **310,** la couche de premier matériau d'intérêt **100a** : la couche de LNO.

### Etape 8.2 :

On procède au dépôt d'une seconde couche d'intérêt **100b** pouvant être une couche de LiTaO₃. L'épaisseur de la couche est comprise entre 0.1 et 5 µm. Celle-ci peut être déposée par ablation laser (PLD - Pulsed Laser Déposition), préférentiellement à des températures de dépôts comprises entre 500 et 700°C, comme illustré en figure 9B.

### Etape 8.3:

On procède au dépôt de l'électrode inférieure **400** (par exemple en Aluminium, par pulvérisation), photolithographie et gravure (par exemple, par voie chimique) de la couche métallique, et retrait de résine, comme illustré en figure 9C.

### Etape 8.4:

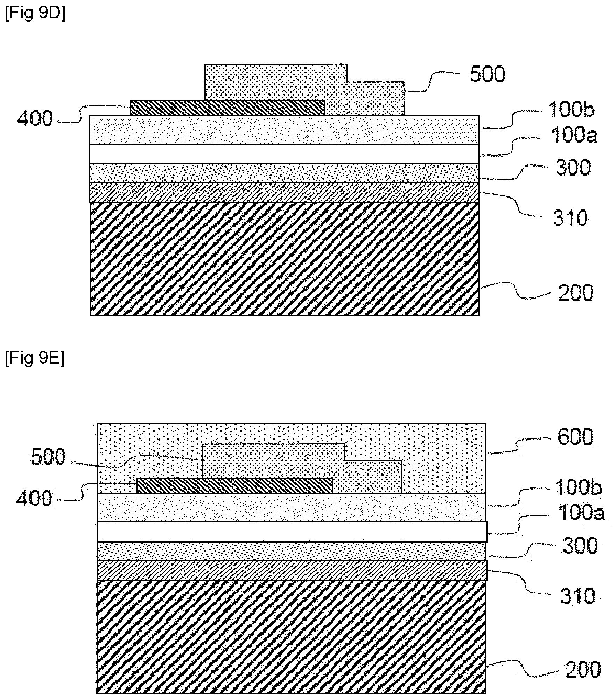

On procède au dépôt d'une couche sacrifiée **500,** par exemple en silicium amorphe, puis à des opérations de photolithographie, gravure ionique réactive et retrait de résine, pour définir des caissons de libération, comme illustré en figure 9D.

### Etape 8.5:

On procède au dépôt d'une couche de collage **600** en vue d'assurer le collage du substrat définitif, comme illustré en figure 9E.

### Etape 8.6:

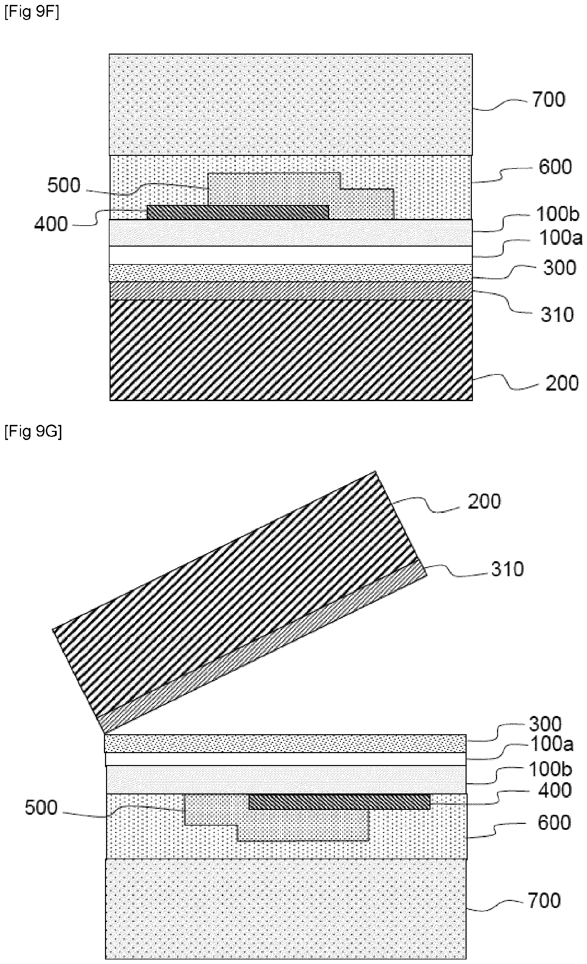

On procède à une opération d'un second collage du substrat temporaire **200** sur le substrat définitif **700.** On reprend dans cet exemple le même procédé que pour le premier collage. Pour s'affranchir des effets de dilatation différentielle, on utilise un substrat définitif en niobate de lithium, et de la même orientation cristalline que celle du substrat temporaire comme illustré en figure 9F.

### Etape 8.7 :

On procède au décollement (détachage) par insertion de lame au niveau de l'interface fragile comprenant la couche **300** comme illustré en figure 9G.

### Etape 8.8:

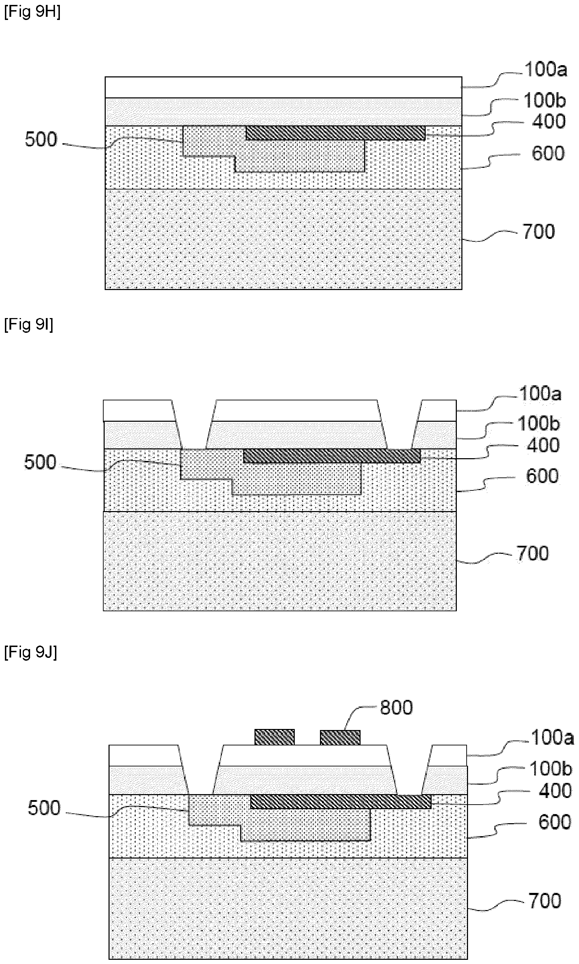

On procède au retrait la couche de l'interface fragile en métal noble **300,** soit dans le cas présent du Pt, par gravure sèche et retrait de l'oxyde en HF comme illustré en figure 9H et laissant à nu la couche d'intérêt **100a.**

On reprend ensuite les mêmes étapes que celles présentées dans l'état de l'art :

### Etape 8.9:

On procède à une opération de gravure d'ouvertures dans le film de niobate de lithium reporté **100a** et dans le film **100b** (dans l'exemple de tantalate de lithium), par exemple par photolithographie, gravure par faisceau d'ions (IBE) et retrait de résine, comme illustré en figure 9I.

### Etape 8.10:

On procède à la formation des électrodes supérieures **800,** par exemple en aluminium, par dépôt par pulvérisation, photolithographie, gravure humide et retrait de résine comme illustré en figure 9J.

### Etape 8.11:

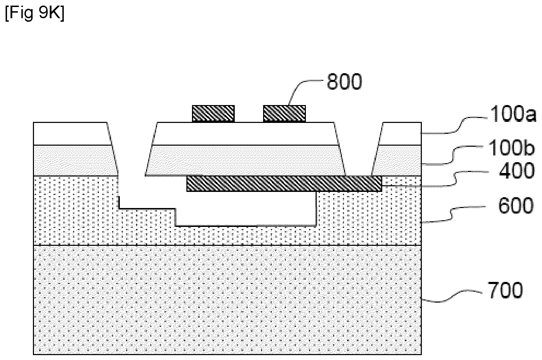

On procède à la libération des membranes contenant les résonateurs, par gravure des caissons de couche sacrifiée **500** (ici par XeF₂ gazeux pour dissoudre les caissons en silicium amorphe), comme illustré en figure 9K.

## Revendications

1. Procédé de fabrication d'un composant comprenant le report d'un ensemble comportant une ou plusieurs couche(s) de matériau(x) monocristallin(s) piézoélectrique(s) ou pyroélectrique(s) ou ferroélectrique(s) sur un substrat final, ledit procédé comprenant au moins :
- un premier ensemble d'étapes comportant :
∘ une étape d'implantation d'ions dans un substrat donneur de matériau monocristallin piézoélectrique ou pyroélectrique ou ferroélectrique (**100**) à un niveau d'implantation de manière à définir une zone de couche (110) dans ledit matériau monocristallin piézoélectrique ou pyroélectrique ou ferroélectrique ;
∘ une étape de premier assemblage dudit substrat donneur de matériau monocristallin piézoélectrique ou pyroélectrique ou ferroélectrique sur un substrat temporaire (**200**), ladite étape de premier assemblage comprenant la réalisation d'une zone d'interface fragile de séparation (300, 310) entre ledit substrat donneur de matériau monocristallin piézoélectrique ou pyroélectrique ou ferroélectrique et ledit substrat temporaire, ladite zone comprenant au moins deux couches de matériaux différents (110, 300, 310) pour assurer la mise en contact de deux composés des couches (110, 310) aptes à générer une interdiffusion d'élément(s) constitutif(s) d'au moins un des deux composés ;
∘ une étape d'amincissement dudit substrat donneur de premier matériau monocristallin piézoélectrique ou pyroélectrique ou ferroélectrique (100) jusqu'au niveau d'implantation définissant une couche de matériau monocristallin piézoélectrique ou pyroélectrique ou ferroélectrique (**100a**);
∘ une étape de guérison des défauts résiduels par recuit thermique de ladite couche de matériau monocristallin piézoélectrique ou pyroélectrique ou ferroélectrique (**100a**);
- et un second ensemble d'étapes postérieures au premier ensemble d'étapes comportant au moins :
∘ une étape de second assemblage d'un ensemble comprenant la ou les couche(s) de matériau(x) monocristallin(s) piézoélectrique(s) ou pyroélectrique(s) ou ferroélectrique(s) et ledit substrat temporaire, avec un substrat final (**700**) ;
∘ une étape de séparation du substrat temporaire (**200**) de ladite couche de matériau monocristallin piézoélectrique ou pyroélectrique ou ferroélectrique, au niveau de ladite zone d'interface fragile de séparation.

2. Procédé de fabrication selon la revendication 1 dans lequel le second ensemble d'étapes comprend une étape de réalisation d'une première structure fonctionnelle sur l'une des couches de matériau monocristallin piézoélectrique ou pyroélectrique ou ferroélectrique.

3. Procédé de fabrication selon l'une des revendications 1 ou 2, dans lequel le second ensemble d'étapes comprend une étape de réalisation d'une seconde structure fonctionnelle (**800**) sur l'une des couches de matériau monocristallin piézoélectrique ou pyroélectrique ou ferroélectrique.

4. Procédé de fabrication selon l'une des revendications 1 à 3, dans lequel après l'étape d'amincissement dudit substrat donneur d'un premier matériau monocristallin piézoélectrique ou pyroélectrique ou ferroélectrique jusqu'au niveau d'implantation définissant une couche de matériau monocristallin piézoélectrique ou pyroélectrique ou ferroélectrique, ledit procédé comprend la réalisation d'une couche supplémentaire de deuxième matériau monocristallin piézoélectrique ou pyroélectrique ou ferroélectrique à la surface de ladite couche de matériau monocristallin piézoélectrique ou pyroélectrique ou ferroélectrique, lesdits premier et deuxième matériaux étant identiques ou différents.

5. Procédé de fabrication selon la revendication 4, dans lequel l'épaisseur de la couche de premier matériau est inférieure ou égale à 1 micron, l'épaisseur de la couche supplémentaire de second matériau est comprise entre 0.1 et 5 microns..

6. Procédé de fabrication selon l'une des revendications 1 à 5, dans lequel la réalisation de ladite zone d'interface fragile de séparation entre ledit substrat donneur de matériau monocristallin piézoélectrique ou pyroélectrique ou ferroélectrique et ledit substrat temporaire comprend au moins :
- la réalisation d'une couche d'oxyde ou de nitrure ;
- le dépôt d'une couche de métal noble ;
- une opération de recuit thermique apte à créer ladite interdiffusion d'élément(s) constitutif(s) d'au moins un des deux composés.

7. Procédé de fabrication selon la revendication 6, comprenant :
- la réalisation d'une couche d'oxyde de silicium ou de nitrure de silicium ;
- le dépôt d'une couche de métal noble de Pt ou de Au ou de Rh ou de Os ou de Pd ou de Ru ou de Ir.

8. Procédé de fabrication selon l'une des revendications 6 ou 7, dans lequel l'étape de guérison des défauts résiduels par recuit thermique est réalisée avec un budget thermique apte à provoquer la diffusion du métal noble dans l'oxyde ou dans le nitrure, ledit budget thermique étant réalisé à une température comprise entre 300°C et 700°C pendant une durée comprise entre 1 heure et 10 heures.

9. Procédé de fabrication selon l'une des revendications 1 à 8, dans lequel l'étape de premier assemblage dudit substrat de matériau monocristallin piézoélectrique ou pyroélectrique ou ferroélectrique sur un substrat temporaire (**200**), est réalisé avec une première couche de collage en matériau constituant l'un des matériaux pour assurer la mise en contact de deux composés aptes à générer une interdiffusion d'élément(s) constitutif(s) d'au moins un des deux composés.

10. Procédé de fabrication selon l'une des revendications 1 à 9, dans lequel l'étape de premier assemblage dudit substrat de matériau monocristallin piézoélectrique ou pyroélectrique ou ferroélectrique sur un substrat temporaire (**200**), est réalisé avec une première couche de collage, ladite première couche de collage étant une couche d'oxyde de silicium (SiO₂), une couche métallique (Cu, Au, Ti, Ag, ...) ou de polymère tel que le benzocyclobutène BCB.

11. Procédé de fabrication selon l'une des revendications 1 à 10, dans lequel l'étape de second assemblage d'un ensemble comprenant la ou les couche(s) de matériau(x) monocristallin(s) piézoélectrique(s) ou pyroélectrique(s) ou ferroélectrique(s) et ledit substrat temporaire, avec un substrat final (**700**) est réalisé avec au moins une seconde couche de collage (**600**), ladite seconde couche de collage étant minérale, par exemple en SiO₂ ou en oxynitrure de silicium (SiOₓN_{y}).

12. Procédé de fabrication selon l'une des revendications 1 à 11, dans lequel l'étape de séparation du substrat temporaire (**200**) est réalisée mécaniquement au niveau de l'interface fragile.

13. Procédé de fabrication selon l'une des revendications 1 à 12, dans lequel le substrat donneur de matériau monocristallin piézoélectrique ou pyroélectrique ou ferroélectrique est en niobate de lithium, ou tantalate de lithium.

14. Procédé de fabrication selon l'une des revendications 1 à 13, dans lequel le substrat temporaire est de même nature que le substrat donneur de matériau monocristallin piézoélectrique ou pyroélectrique ou ferroélectrique.

15. Procédé de fabrication selon l'une des revendications 1 à 14, dans lequel le substrat final est en matériau de type niobate de lithium, tantalate de lithium ou silicium ou verre ou saphir.

16. Procédé de fabrication d'un composant selon l'une des revendications 2 à 15 et comportant :
- la réalisation d'une première structure fonctionnelle métallique (**400**) sur une première face de ladite couche de matériau monocristallin piézoélectrique ou pyroélectrique ou ferroélectrique, configurée pour être une électrode continue ou une série d'électrodes discontinues ;
- la réalisation d'une seconde structure fonctionnelle métallique (**800**) sur la face opposée de ladite couche de matériau monocristallin piézoélectrique ou pyroélectrique ou ferroélectrique ou sur une face opposée d'une autre couche de matériau monocristallin piézoélectrique ou pyroélectrique ou ferroélectrique, configurée pour être une électrode continue ou une série d'électrodes discontinues, ladite première face correspondant à la face amincie du substrat donneur de matériau monocristallin piézoélectrique ou pyroélectrique.

17. Procédé de fabrication selon l'une des revendications 1 à 16, ledit composant étant un résonateur à ondes acoustiques, ledit procédé comprenant :
- le dépôt d'une couche sacrificiée (**500**) à la surface d'une couche de matériau monocristallin piézoélectrique ou pyroélectrique ou ferroélectrique ou à la surface de la couche supplémentaire de deuxième matériau monocristallin piézoélectrique ou pyroélectrique ou ferroélectrique et/ou à la surface de la première structure fonctionnelle métallique, ladite couche sacrifiée par exemple en silicium amorphe ;
- la réalisation d'au moins un caisson dans ladite couche sacrifiée (**500**) ;
- une opération de gravure dudit caisson de manière à réaliser une membrane suspendue de matériau monocristallin piézoélectrique ou pyroélectrique ou ferroélectrique.

18. Procédé de fabrication selon l'une des revendications 1 à 16, ledit composant étant un résonateur à ondes acoustiques, ledit procédé comprenant la réalisation de cavités dans ledit substrat final (**700**) avant l'opération de second assemblage.

19. Procédé de fabrication selon l'une des revendications 1 à 16, ledit composant étant un résonateur à ondes acoustiques, ledit procédé comprenant la réalisation d'un empilement avec alternativement des couches présentant des impédances acoustiques différentes, par exemple, SiO₂/W, ou SiO₂/Mo, ou SiO₂/AlN ou SiOC/SiN, ... **(600, 610, 601, 620)** à la surface de la couche de matériau monocristallin piézoélectrique ou pyroélectrique ou ferroélectrique ou à la surface de la couche supplémentaire de second matériau piézoélectrique ou pyroélectrique ou ferroélectrique **(100a, 101a, 102a),** pour réaliser une structure de miroirs de Bragg.

20. Procédé de fabrication selon l'une des revendications 1 à 19, ledit composant comportant un ensemble d'au moins deux résonateurs à ondes élastiques de volume empilés et comprenant :
o la fabrication d'un résonateur comprenant au moins une première couche de matériau monocristallin piézoélectrique ou pyroélectrique ou ferroélectrique **(101a),** une première structure fonctionnelle métallique **(401),** une seconde structure fonctionnelle métallique (**801**) sur un substrat final (**701**) ;
o le dépôt d'une ou de plusieurs couche(s) d'isolation ou de couplage acoustique à la surface dudit premier résonateur (**901**);
o la réalisation d'une première structure fonctionnelle métallique **(402)** apte à former une première électrode d'un second résonateur à la surface de ladite ou de l'une desdites couche(s) d'isolation acoustique ou de couplage acoustique;
o le report d'une seconde couche **(102a)** de matériau monocristallin piézoélectrique ou pyroélectrique ou ferroélectrique reporté sur un substrat temporaire **(202**) via une zone d'interface fragile de séparation **(302, 312)** à la surface dudit substrat temporaire (**202**) ;
o le retrait dudit substrat temporaire de manière à laisser libre une seconde face de ladite seconde couche active **(102a)** ;
o la réalisation d'une seconde structure fonctionnelle métallique (**802**), de manière à définir le second résonateur.

21. Procédé de fabrication selon l'une des revendications 1 à 16, ledit composant étant un capteur pyroélectrique comprenant une couche active (**100a**) comprise entre deux électrodes continues **(400, 800),** la couche de matériau monocristallin piézoélectrique ou pyroélectrique ou ferroélectrique, par exemple en tantalate de lithium, ledit procédé comprend en outre la gravure partielle en face arrière du substrat final **(700)** par exemple en silicium de manière à définir une membrane dans ledit substrat final.

22. Procédé de fabrication selon l'une des revendications 1 à 21, dans lequel la zone d'interface fragile comprend une couche de métal noble et une autre couche comprenant au moins l'un des matériaux suivants :
- un oxyde ;
- un nitrure ;
- un oxynitrure de silicium ;
- un oxycarbure de silicium SiOC ;
- un fluor SiOF.

## Patentansprüche

1. Verfahren zur Herstellung eines Bauteils, welches das Übertragen einer Anordnung, umfassend eine oder mehrere Schicht(en) aus einem oder mehreren monokristallinen, piezoelektrischen oder pyroelektrischen oder ferroelektrischen Material(ien), auf ein Endsubstrat umfasst, wobei das Verfahren mindestens Folgendes umfasst:
- einen ersten Satz von Schritten, der Folgendes umfasst:
∘ einen Schritt des Implantierens von Ionen in ein Spendersubstrat aus monokristallinem, piezoelektrischem oder pyroelektrischem oder ferroelektrischem Material (100) auf einer Implantationsebene, sodass ein Schichtbereich (110) in dem monokristallinen, piezoelektrischen oder pyroelektrischen oder ferroelektrischen Material definiert wird;
∘ einen Schritt des ersten Zusammenfügens des Spendersubstrats aus monokristallinem, piezoelektrischem oder pyroelektrischem oder ferroelektrischem Material auf einem temporären Substrat (200), wobei der Schritt des ersten Zusammenfügens das Herstellen eines zerbrechlichen Trenn-Schnittstellenbereichs (300, 310) zwischen dem Spendersubstrat aus monokristallinem, piezoelektrischem oder pyroelektrischem oder ferroelektrischem Material und dem temporären Substrat umfasst, wobei der Bereich mindestens zwei Schichten aus unterschiedlichen Materialien (110, 300, 310) umfasst, um den Kontakt von zwei Verbindungen der Schichten (110, 310) zu gewährleisten, die in der Lage sind, eine Interdiffusion von einem oder mehreren Bestandteil(en) von mindestens einer der beiden Verbindungen zu erzeugen;
∘ einen Schritt des Schmälerns des Spendersubstrats (100) aus einem ersten monokristallinen, piezoelektrischen oder pyroelektrischen oder ferroelektrischen Material bis auf eine Implantationsebene, wodurch eine Schicht aus monokristallinem, piezoelektrischem oder pyroelektrischem oder ferroelektrischem Material (100a) definiert wird;
∘ einen Schritt des Heilens der Restdefekte durch thermisches Glühen der Schicht aus monokristallinem, piezoelektrischem oder pyroelektrischem oder ferroelektrischem Material (100a);
- und einen zweiten Satz von Schritten nach dem ersten Satz von Schritten, mindestens Folgendes umfassend:
o einen Schritt des zweiten Zusammenfügens einer Anordnung, welche die Schicht(en) aus einem oder mehreren monokristallinen, piezoelektrischen oder pyroelektrischen oder ferroelektrischen Material(ien) und das temporäre Substrat umfasst, mit einem endgültigen Substrat (700);
∘ einen Schritt des Trennens des temporären Substrats (200) von der Schicht aus monokristallinem, piezoelektrischem oder pyroelektrischem oder ferroelektrischem Material auf Höhe des zerbrechlichen Trenn-Schnittstellenbereichs.

2. Herstellungsverfahren nach Anspruch 1, wobei der zweite Satz von Schritten einen Schritt umfasst, bei dem eine erste Funktionsstruktur auf einer der Schichten aus monokristallinem, piezoelektrischem oder pyroelektrischem oder ferroelektrischem Material hergestellt wird.

3. Herstellungsverfahren nach einem der Ansprüche 1 oder 2, wobei der zweite Satz von Schritten einen Schritt zur Herstellung einer zweiten Funktionsstruktur (800) auf einer der Schichten aus monokristallinem, piezoelektrischem oder pyroelektrischem oder ferroelektrischem Material umfasst.

4. Herstellungsverfahren nach einem der Ansprüche 1 bis 3, wobei nach dem Schritt des Schmälerns des Spendersubstrats aus einem ersten monokristallinen, piezoelektrischen oder pyroelektrischen oder ferroelektrischen Material auf die Implantationsebene, wodurch eine Schicht aus monokristallinem, piezoelektrischem oder pyroelektrischem oder ferroelektrischem Material definiert wird, das Verfahren das Herstellen einer zusätzlichen Schicht aus einem zweiten monokristallinen, piezoelektrischen oder pyroelektrischen oder ferroelektrischen Material auf der Oberfläche der Schicht aus monokristallinem, piezoelektrischem oder pyroelektrischem oder ferroelektrischem Material umfasst, wobei das erste und das zweite Material gleich oder verschieden sind.

5. Herstellungsverfahren nach Anspruch 4, wobei die Dicke der Schicht aus erstem Material kleiner oder gleich 1 Mikrometer ist, die Dicke der zusätzlichen Schicht aus zweitem Material zwischen 0,1 und 5 Mikrometern liegt.

6. Herstellungsverfahren nach einem der Ansprüche 1 bis 5, wobei die Herstellung des zerbrechlichen Trenn-Schnittstellenbereichs zwischen dem Spendersubstrat aus monokristallinem, piezoelektrischem oder pyroelektrischem oder ferroelektrischem Material und dem temporären Substrat mindestens Folgendes umfasst:
- die Herstellung einer Oxid- oder Nitridschicht;
- die Ablagerung einer Schicht aus einem Edelmetall;
- einen thermischen Glühvorgang, der in der Lage ist, die genannte Interdiffusion von einem oder mehreren Bestandteil(en) von mindestens einer der beiden Verbindungen zu erzeugen.

7. Herstellungsverfahren nach Anspruch 6, Folgendes umfassend:
- die Herstellung einer Schicht aus Siliziumoxid oder Siliziumnitrid;
- die Ablagerung einer Schicht aus einem Edelmetall aus Pt oder Au oder Rh oder Os oder Pd oder Ru oder Ir.

8. Herstellungsverfahren nach einem der Ansprüche 6 oder 7, wobei der Schritt des Heilens der Restdefekte durch thermisches Glühen mit einem thermischen Budget durchgeführt wird, das in der Lage ist, die Diffusion des Edelmetalls in das Oxid oder in das Nitrid zu bewirken, wobei das thermische Budget bei einer Temperatur zwischen 300 °C und 700 °C über eine Dauer zwischen 1 Stunde und 10 Stunden durchgeführt wird.

9. Herstellungsverfahren nach einem der Ansprüche 1 bis 8, wobei der Schritt des ersten Zusammenfügens des Substrats aus monokristallinem, piezoelektrischem oder pyroelektrischem oder ferroelektrischem Material auf einem temporären Substrat (200) mit einer ersten Klebeschicht aus einem Material durchgeführt wird, das eines der Materialien bildet, um den Kontakt zwischen zwei Verbindungen zu gewährleisten, die in der Lage sind, eine Interdiffusion von einem oder mehreren Bestandteil(en) von mindestens einer der beiden Verbindungen zu erzeugen.

10. Herstellungsverfahren nach einem der Ansprüche 1 bis 9, wobei der Schritt des ersten Zusammenfügens des Substrats aus monokristallinem, piezoelektrischem oder pyroelektrischem oder ferroelektrischem Material auf einem temporären Substrat (200) mit einer ersten Klebeschicht durchgeführt wird, wobei die erste Klebeschicht eine Schicht aus Siliziumoxid (SiO₂) besteht, eine Metallschicht (Cu, Au, Ti, Ag, ...) oder eine Schicht aus einem Polymer wie Benzocyclobuten (BCB) ist.

11. Herstellungsverfahren nach einem der Ansprüche 1 bis 10, wobei der Schritt des zweiten Zusammenfügens einer Anordnung, welche die Schicht(en) aus einem oder mehreren monokristallinen, piezoelektrischen oder pyroelektrischen oder ferroelektrischen Material(ien) und das temporäre Substrat umfasst, mit einem endgültigen Substrat (700) mit mindestens einer zweiten Klebeschicht (600) durchgeführt wird, wobei die zweite Klebeschicht mineralisch ist, z. B. bestehend aus SiO₂ oder Siliziumoxynitrid (SiOₓN_{y}).

12. Herstellungsverfahren nach einem der Ansprüche 1 bis 11, wobei der Schritt des Trennens des temporären Substrats (200) mechanisch auf Höhe der zerbrechlichen Schnittstelle durchgeführt wird.

13. Herstellungsverfahren nach einem der Ansprüche 1 bis 12, wobei das Spendersubstrat aus monokristallinem, piezoelektrischem oder pyroelektrischem oder ferroelektrischem Material aus Lithiumniobat oder Lithiumtantalat besteht.

14. Herstellungsverfahren nach einem der Ansprüche 1 bis 13, wobei das temporäre Substrat von derselben Art ist wie das Spendersubstrat aus monokristallinem, piezoelektrischem oder pyroelektrischem oder ferroelektrischem Material.

15. Herstellungsverfahren nach einem der Ansprüche 1 bis 14, wobei das endgültige Substrat aus einem Material vom Typ Lithiumniobat, Lithiumtantalat oder Silizium oder Glas oder Saphir besteht.

16. Verfahren zum Herstellen eines Bauteils nach einem der Ansprüche 2 bis 15 und Folgendes umfassend:
- die Herstellung einer ersten metallischen Funktionsstruktur (400) auf einer ersten Seite der Schicht aus monokristallinem, piezoelektrischem oder pyroelektrischem oder ferroelektrischem Material, die so konfiguriert ist, dass sie eine kontinuierliche Elektrode oder eine Reihe von diskontinuierlichen Elektroden ist;
- die Herstellung einer zweiten metallischen Funktionsstruktur (800) auf der gegenüberliegenden Seite der Schicht aus monokristallinem, piezoelektrischem oder pyroelektrischem oder ferroelektrischem Material oder auf einer gegenüberliegenden Seite einer anderen Schicht aus monokristallinem, piezoelektrischem oder pyroelektrischem oder ferroelektrischem Material, die so konfiguriert ist, dass sie eine kontinuierliche Elektrode oder eine Reihe von diskontinuierlichen Elektroden ist, wobei die erste Seite der geschmälerten Seite des Spendersubstrats aus monokristallinem, piezoelektrischem oder pyroelektrischem Material entspricht.

17. Herstellungsverfahren nach einem der Ansprüche 1 bis 16, wobei das Bauteil ein Resonator für akustische Wellen ist, wobei das Verfahren Folgendes umfasst:
- die Ablagerung einer Opferschicht (500) auf die Oberfläche einer Schicht aus monokristallinem, piezoelektrischem oder pyroelektrischem oder ferroelektrischem Material oder auf die Oberfläche der zusätzlichen Schicht aus zweitem monokristallinem, piezoelektrischem oder pyroelektrischem oder ferroelektrischem Material und/oder auf die Oberfläche der ersten metallischen Funktionsstruktur, wobei die Opferschicht beispielsweise aus amorphem Silizium besteht;
- die Herstellung von mindestens einer Wanne in der Opferschicht (500);
- einen Schritt des Ätzens der Wanne, um eine hängende Membran aus einem monokristallinen, piezoelektrischen oder pyroelektrischen oder ferroelektrischen Material herzustellen.

18. Herstellungsverfahren nach einem der Ansprüche 1 bis 16, wobei das Bauteil ein Resonator für akustische Wellen ist, wobei das Verfahren das Herstellen von Hohlräumen in dem endgültigen Substrat (700) vor dem zweiten Schritt des Zusammenfügens umfasst.

19. Herstellungsverfahren nach einem der Ansprüche 1 bis 16, wobei das Bauteil ein Resonator für akustische Wellen ist, wobei das Verfahren die Herstellung eines Stapels mit abwechselnd Schichten umfasst, die unterschiedliche akustische Impedanzen aufweisen, z. B. SiO₂/W oder SiO₂/Mo oder SiO₂/AlN oder SiOC/SiN usw. (600, 610, 601, 620) an der Oberfläche der Schicht aus monokristallinem, piezoelektrischem oder pyroelektrischem oder ferroelektrischem Material oder an der Oberfläche der zusätzlichen Schicht aus zweitem piezoelektrischem oder pyroelektrischem oder ferroelektrischem Material (100a, 101a, 102a), um eine Bragg-Spiegelstruktur herzustellen.

20. Herstellungsverfahren nach einem der Ansprüche 1 bis 19, wobei das Bauteil eine Anordnung von mindestens zwei gestapelten Resonator für elastische Volumenwellen aufweist, Folgendes umfassend:
∘ die Herstellung eines Resonators, der mindestens eine erste Schicht aus monokristallinem, piezoelektrischem oder pyroelektrischem oder ferroelektrischem Material (101a), eine erste metallische Funktionsstruktur (401), eine zweite metallische Funktionsstruktur (801) auf einem Endsubstrat (701) umfasst;
∘ die Ablagerung einer oder mehrerer akustischer Isolier- oder Kopplungsschicht(en) auf der Oberfläche des ersten Resonators (901);
o die Herstellung einer ersten metallischen Funktionsstruktur (402), die in der Lage ist, eine erste Elektrode eines zweiten Resonators auf der Oberfläche der einen oder der mehreren akustischen Isolations- oder Kopplungsschicht(en) zu bilden;
o die Übertragung einer zweiten Schicht (102a) aus monokristallinem, piezoelektrischem oder pyroelektrischem oder ferroelektrischem Material, das auf ein temporäres Substrat (202) über einen zerbrechlichen Trenn-Schnittstellenbereich (302, 312) auf die Oberfläche des temporären Substrats (202) übertragen wurde;
∘ die Entfernung des temporären Substrats, sodass eine zweite Seite der zweiten aktiven Schicht (102a) frei bleibt;
o die Herstellung einer zweiten metallischen Funktionsstruktur (802), um so den zweiten Resonator zu definieren.

21. Herstellungsverfahren nach einem der Ansprüche 1 bis 16, wobei das Bauteil ein pyroelektrischer Sensor ist, der eine aktive Schicht (100a) umfasst, die zwischen zwei kontinuierlichen Elektroden (400, 800) enthalten ist, wobei die Schicht aus monokristallinem, piezoelektrischem oder pyroelektrischem oder ferroelektrischem Material, beispielsweise aus Lithiumtantalat, besteht, wobei das Verfahren ferner das teilweise rückseitige Ätzen des endgültigen Substrats (700), beispielsweise aus Silizium, umfasst, um eine Membran in dem endgültigen Substrat zu definieren.

22. Herstellungsverfahren nach einem der Ansprüche 1 bis 21, wobei der zerbrechliche Trenn-Schnittstellenbereich eine Schicht aus Edelmetall und eine weitere Schicht umfasst, die mindestens eines der folgenden Materialien umfasst:
- ein Oxid;
- ein Nitrid;
- ein Siliziumoxynitrid;
- ein Siliziumoxycarbid (SiOC);
- ein Fluor SiOF.

## Claims

1. A method for fabricating a component comprising transferring an assembly having one or more layers of one or more single-crystal piezoelectric or pyroelectric or ferroelectric materials to a final substrate, said method comprising at least:
- a first set of steps comprising:
∘ a step of implanting ions into a donor substrate of single-crystal piezoelectric or pyroelectric or ferroelectric material (100) at an implantation level so as to define a layer region (110) in said single-crystal piezoelectric or pyroelectric or ferroelectric material;
∘ a first joining step of joining said donor substrate of single-crystal piezoelectric or pyroelectric or ferroelectric material to a temporary substrate (200), said first joining step comprising producing a fragile separating interface region (300, 310) between said donor substrate of single-crystal piezoelectric or pyroelectric or ferroelectric material and said temporary substrate, said region comprising at least two layers of different materials (110, 300, 310) in order to ensure that two compounds of the layers (110, 310), capable of generating an interdiffusion of one or more constituent elements of at least one of the two compounds, come into contact;
∘ a step of thinning said donor substrate (100) of single-crystal piezoelectric or pyroelectric or ferroelectric material to the implantation level so as to define a layer of single-crystal piezoelectric or pyroelectric or ferroelectric material (100a);
∘ a step of healing residual defects via thermal annealing of said layer of single-crystal piezoelectric or pyroelectric or ferroelectric material (100a);
- and a second set of steps subsequent to the first set of steps, comprising at least:
∘ a second joining step of joining an assembly comprising the one or more layers of one or more single-crystal piezoelectric or pyroelectric or ferroelectric materials and said temporary substrate to a final substrate (700);
∘ a step of separating the temporary substrate (200) from said layer of single-crystal piezoelectric or pyroelectric or ferroelectric material, at said fragile separating interface region.

2. The fabrication method according to claim 1, wherein the second set of steps comprises a step of producing a first functional structure on one of the layers of single-crystal piezoelectric or pyroelectric or ferroelectric material.

3. The fabrication method according to one of claims 1 or 2, wherein the second set of steps comprises a step of producing a second functional structure (800) on one of the layers of single-crystal piezoelectric or pyroelectric or ferroelectric material.

4. The fabrication method according to one of claims 1 to 3, wherein, after the step of thinning said donor substrate, which is made of a first single-crystal piezoelectric or pyroelectric or ferroelectric material, to the implantation level, so as to define a layer of single-crystal piezoelectric or pyroelectric or ferroelectric material, said method comprises producing an additional layer of second single-crystal piezoelectric or pyroelectric or ferroelectric material on the surface of said layer of single-crystal piezoelectric or pyroelectric or ferroelectric material, said first and second materials being identical or different.

5. The fabrication method according to claim 4, wherein the thickness of the layer of first material is smaller than or equal to 1 micron, the thickness of the additional layer of second material is comprised between 0.1 and 5 microns.

6. The fabrication method according to one of claims 1 to 5, wherein production of said fragile separating interface region between said donor substrate of single-crystal piezoelectric or pyroelectric or ferroelectric material and said temporary substrate comprises at least:
- producing a layer of oxide or of nitride;
- depositing a layer of noble metal;
- carrying out a thermal anneal capable of creating said interdiffusion of one or more constituent elements of at least one of the two compounds.

7. The fabrication method according to claim 6, comprising:
- producing a layer of silicon oxide or of silicon nitride;
- depositing a layer of noble metal of Pt or of Au or of Rh or of Os or of Pd or of Ru or of Ir.

8. The fabrication method according to one of claims 6 or 7, wherein the step of healing the residual defects via thermal annealing is carried out with a thermal budget capable of causing the diffusion of the noble metal into the oxide or into the nitride, said thermal budget being spent at a temperature comprised between 300°C and 700°C for a time comprised between 1 hour and 10 hours.

9. The fabrication method according to one of claims 1 to 8, wherein the first joining step of joining said substrate of single-crystal piezoelectric or pyroelectric or ferroelectric material to a temporary substrate (200), is carried out with a first bonding layer made of a constituent material of one of the materials to ensure that two compounds capable of generating an interdiffusion of one or more constituent elements of at least one of the two compounds make contact.

10. The fabrication method according to one of claims 1 to 9, wherein the first joining step of joining said substrate of single-crystal piezoelectric or pyroelectric or ferroelectric material to a temporary substrate (200), is carried out with a first bonding layer, said first bonding layer being a layer of silicon oxide (SiO₂), a metal layer (Cu, Au, Ti, Ag, etc.) or a layer of a polymer such as benzocyclobutane (BCB).

11. The fabrication method according to one of claims 1 to 10, wherein the second joining step of joining an assembly, comprising the one or more layers of one or more single-crystal piezoelectric or pyroelectric or ferroelectric materials and said temporary substrate, to a final substrate (700), is carried out with at least one second bonding layer (600), said second bonding layer being mineral, and for example made of SiO₂ or of silicon oxynitride (SiOₓN_{y}).

12. The fabrication method according to one of claims 1 to 11, wherein the step of separating the temporary substrate (200) is carried out mechanically, at the fragile interface.

13. The fabrication method according to one of claims 1 to 12, wherein the donor substrate of single-crystal piezoelectric or pyroelectric or ferroelectric material is made of lithium niobate, or lithium tantalate.

14. The fabrication method according to one of claims 1 to 13, wherein the temporary substrate is of the same nature as the donor substrate of single-crystal piezoelectric or pyroelectric or ferroelectric material.

15. The fabrication method according to one of claims 1 to 14, wherein the final substrate is made of a material such as lithium niobate, lithium tantalate or silicon or glass or sapphire.

16. The method for fabricating a component according to one of claims 2 to 15 and comprising:
- producing a first metal functional structure (400) on a first face of said layer of single-crystal piezoelectric or pyroelectric or ferroelectric material, said structure being configured to be a continuous electrode or a series of discontinuous electrodes;
- producing a second metal functional structure (800) on the opposite face of said layer of single-crystal piezoelectric or pyroelectric or ferroelectric material or on an opposite face of another layer of single-crystal piezoelectric or pyroelectric or ferroelectric material, said structure being configured to be a continuous electrode or a series of discontinuous electrodes, said first face corresponding to the thinned face of the donor substrate of single-crystal piezoelectric or pyroelectric material.

17. The fabrication method according to one of claims 1 to 16, said component being an acoustic wave resonator, said method comprising:
- depositing a sacrificial layer (500) on the surface of a layer of single-crystal piezoelectric or pyroelectric or ferroelectric material or on the surface of the additional layer of second single-crystal piezoelectric or pyroelectric or ferroelectric material and/or on the surface of the first metal functional structure, said sacrificial layer for example being made of amorphous silicon;
- producing at least one well in said sacrificial layer (500);
- etching said well so as to produce a suspended membrane of single-crystal piezoelectric or pyroelectric or ferroelectric material.

18. The fabrication method according to one of claims 1 to 16, said component being an acoustic-wave resonator, said method comprising producing cavities in said final substrate (700) before the second joining step.

19. The fabrication method according to one of claims 1 to 16, said component being an acoustic-wave resonator, said method comprising producing a stack with, in alternation, layers having different acoustic impedances, for example, SiO₂/W, or SiO₂/Mo, or SiO₂/AlN or SiOC/SiN, etc. (600, 610, 601, 620), on the surface of the layer of single-crystal piezoelectric or pyroelectric or ferroelectric material or on the surface of the additional layer of second piezoelectric or pyroelectric or ferroelectric material (100a, 101a, 102a), to produce a Bragg-mirror structure.

20. The fabrication method according to one of claims 1 to 19, said component having a set of at least two stacked bulk-elastic-wave resonators, said method comprising:
o fabricating a resonator comprising at least a first layer of single-crystal piezoelectric or pyroelectric or ferroelectric material (101a), a first metal functional structure (401), and a second metal functional structure (801), on a final substrate (701);
o depositing one or more acoustically coupling or isolating layers on the surface of said first resonator (901);
o producing a first metal functional structure (402) capable of forming a first electrode of a second resonator on the surface of said one or more acoustically isolating or acoustically coupling layers;
o transferring a second layer (102a) of single-crystal piezoelectric or pyroelectric or ferroelectric material, transferred to a temporary substrate (202) via a fragile separating interface region (302, 312) on the surface of said temporary substrate (202);
o removing said temporary substrate so as to leave a second face of said second active layer (102a) free;
o producing a second metal functional structure (802), so as to define the second resonator.

21. The fabrication method according to one of claims 1 to 16, said component being a pyroelectric sensor comprising, between two continuous electrodes (400, 800), an active layer (100a), the layer of single-crystal piezoelectric or pyroelectric or ferroelectric material, such as lithium tantalate, said method further comprises partially etching, from the back side, the final substrate (700), which is for example made of silicon, so as to define a membrane in said final substrate.

22. The fabrication method according to one of claims 1 to 21, wherein the fragile interface region comprises a layer of noble metal and another layer comprising at least one of the following materials:
- an oxide;
- a nitride;
- a silicon oxynitride;
- a silicon oxycarbide (SiOC);
- a fluorine SiOF.
